# EUROPÄISCHE PATENTANMELDUNG

(11) **EP 0 626 585 A1**
(43) Veröffentlichungstag der Anmeldung: **30.11.1994**
(21) Anmeldenummer: 94107278.7
(22) Anmeldetag: 10.05.1994
(51) Int. Cl.: G01R 31/26

(54) **Programmierbares und vollelektronisches Transistormessgerät**

(30) Priorität: 15.05.1993 DE 9307408 U; 08.12.1993 DE 9318765 U
(71) Anmelder: Wintjens, Rüdiger, D-47533 Kleve 1 (DE)
(72) Erfinder: Wintjens, Rüdiger, D-47533 Kleve 1 (DE)

(57) **Zusammenfassung**

Die Erfindung betrifft ein programmierbares und vollelektronisches Transistormeßgerät, welches selbstätig und ohne äußeres Hinzutun über die Transistoreinzel- überprüfung hinaus auch Funktionsüberprüfungen von Transistoren im unausge- löteten Zustand in Niederfrequenz - als auch Hochfrequenzschaltungen durchführt und nach Abschluß der Überprüfung die wichtigsten physikalischen Parameter digital zur Anzeige bringt. Das System der Suchlaufeinrichtung erlaubt uneingeschränkt die Überprüfung beliebiger Transistoren, wobei über einen SMD-Bauteilprüfstift die SMD-Halbleiterbausteine mit einbezogen werden. Über den integrierten NC-Dekoder erfolgt die Mitteilung der korrekten Kontaktgebung des zu überprüfenden Transistors mit der Meßelektronik.

## Beschreibung

Die Erfindung betrifft ein programmierbares - und vollelektronisches Transistormeßgerät, welches ohne äußere Hinzutun über die Transistoreinzellmessung hinaus auch Funktionsüberprüfungen von Transistoren im unausgelötetem Zustand auf den Leiterplatten in Niederfrequenzschaltungen als auch Hochfrequenzschaltungen, wie solchen der Tunerbausteinen erlaubt und nach Abschluß der Messungen nachstehende Ermittlungen selbsttätig und digital zur Anzeige bringt:
a.) Transistoranschlüsse: Basisanschluß, Emitteranschluß, Kollektoranschluß;
b.) Dotierungsfolge: NPN-Transistor oder PNP-Transistor;
c.) Ausgangsdotierungsmaterial: Siliziumtransistor oder Germaniumtransistor;
d.) Transistoreinsatzbereich: NF-Transistor oder HF-Transistor;
e.) Schaltzeit des Transistors: zeigt in µ-Sek./n-Sekundenauflösung die Transistorschaltzeit;
f.) Absolut-Allzeige: Zeigt definitiv an, wenn der Prüfling Transistor defekt ist;
g.) Absolut-Allzeige: Zeigt definitiv an, wann die Messungen um den Transistor beendet sind;
h.) Anzeige zur Selektierung: +U_{BE} - Spannung bzw. -U_{EB} - Spannung;
   Die Programmsteuerung des Transistormeßgerätes beinhaltet:
i.) Vollmessung: selbstätige Ermittlung der Größen a.).................bis...............h.)
j.) NF-Transistor-Messung: Messungen beziehen sich allein auf NF-Transistoren;
k.) HF-Transistor-Messung: Messungen beziehen sich allein auf HF-Transistoren;
m.) Einzelschritt-Messungen: die Meßgeschwindigkeit wird nicht von einem Oszillator bestimmt, sondern manuell Schritt für Schritt über z.B. einer Digit-Taste vorgegeben. Die gesamte Elektronik ist so gestaltet, daß keine Abgleicharbeiten erforderlich sind.
   Das Transistormeßgerät kann absolut kontaktlos oder wahlweise mit in der Schaltung befindlichen Relais (= nicht kontaktlos) aufgebaut werden. Analog zu den genannten Eigenschaften erlaubt das System der Suchlaufeinrichtung auch die Überprüfung beliebiger Unipolar-Transistoren (=Feldeffekt-Transistoren) und ein spezieller SMD-Bauteilprüfstift erlaubt die direkte Überprüfung von aktiven SMD-Halbleiterbausteinen auf den Leiterplatten über nur einem Meßkabel. Über das Modul eines NC-Dekoders wird nach Wunsch selbstätig und ohne äußeres Hinzutun eine Überprüfung der korrekten Kontaktgebung des Prüflings mit der Meßelektronik durchgeführt und akustisch und digital zur Anzeige gebracht.

Die auf dem Markt befindlichen Transistorprüfgeräte sind in der Regel mit einem Netzteil ausgerüstet und ebenfalls in der Lage, nicht nur die Transistoranschlüsse, sondern auch die Dotierungsfolge (NPN- oder PNP-Transistor) zu ermitteln. Dabei kann ein Transistor sowohl in eingebautem als auch ausgebauten Zustand überprüft werden.

Bei einem Transistorprüfgerät (DE-OS 20 59 463) ist die Suchlaufeinrichtung ein motorgetriebener Drehwähler, der die für die Prüfung der Transistoranschlüsse notwendigen Schalterstellungen durchläuft und angehalten wird, wenn die gesuchte Schalterstellung erreicht ist. Dann werden die Belegung der Transistoranschlüsse sowie des Transistortyps angezeigt. Die mechanischen Bauteile dieses Transistorprüfgerätes sind störanfällig und nicht wartungsfrei. Bei schlechter Kontaktgebung des Prüflings läuft der Drehwähler unermüdlich durch, was darüber hinaus auch dann der Fall ist, wenn der Prüfling Transistor defekt ist. Somit kann diese Prüfanordnung beim ständigen Durchlaufen nicht die eindeutige Aussage darüber erbringen, ob ein Transistor defekt ist oder nicht.

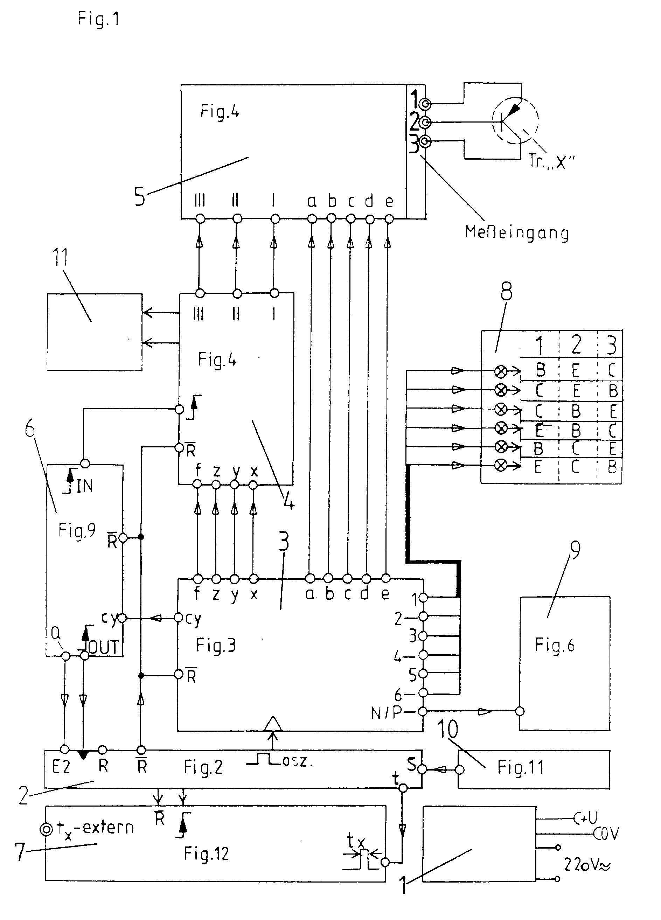

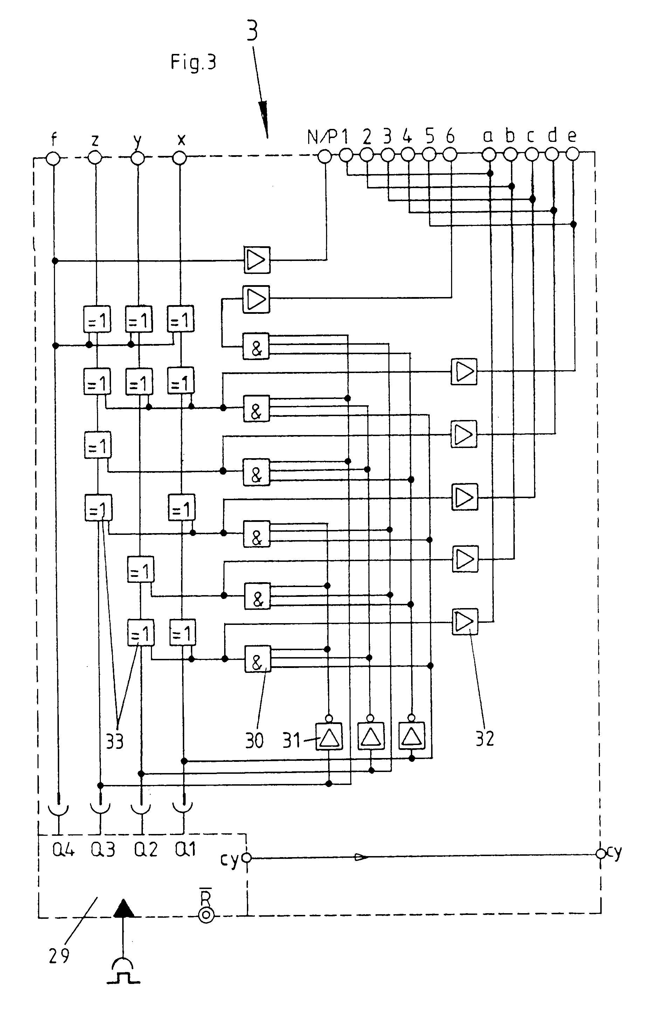

So ist die Funktion der Suchlaufeinrichtung beim Transistorprüfgerät (G 92 13 150.0) nicht eindeutig der Fig. 3 zu entnehmen, da sich die "Schaltzeichen" stark den festgesetzten Konventionen bezüglich der Normierungen entziehen. Nach Fig.3 ist die Funktion der Suchlaufeinrichtung darauf zurückzuführen, daß beispielsweise die Basis eines zu überprüfenden NPN-Transistors z.B. über den neutralen Anschluß P1 solange mit sich zeitlich unterschiedlich auftretenden Impulsbreiten angesteuert wird, bis über den Schalter (3) der Prüfling die für sein Durchschalten erforderlichen Spannungspegel über die verbleibenden Anschlußklemmen P2 und P3 an seinem Kollektor als auch seinem Emitter anliegen hat. Dem Diagramm unter Fig. 3 ist außerdem zu entnehmen, daß mit den eingezeichneten Spannungspegeln kein NPN-Transistor angesteuert werden kann. Um dieses zu erreichen, muß der NPN-/PNP- Schalter Fig.1 manuell auf NPN-Transistorüberprüfung umgelegt werden, bevor eine erneute Prüfung eingeleitet werden kann. Die Herausfindung der Transistoranschlüsse eines unbekannten Transistors sind mit diesem Suchlaufsystem so unvorteilhaft gestaltet, sodaß manuelle Schalterbedienungen erforderlich werden.

Beim Transistorprüfgerät (DD 223 831 A1) bezieht sich die Erfindung allein auf die Anschlußerkennung von Transistoren. Darüber hinaus weist diese Erfindung bezüglich der Anschlußerkennung von Transistoren nachstehende Nachteile auf: 1.) Mit der Anordnung entsprechend Fig.1 lassen sich nur NPN-Transistoren und P-Kanal-Feldeffekttransistoren überprüfen. 2.) Die Anordnung entsprechend Fig.1 erlaubt nicht die Überprüfung von PNP-Transistoren bzw. N-Kanal-Feldeffekttransistoren. Zu diesem Zweck muß eine weitere vergleichbare Prüfanordnung entsprechend Fig.1 mit um 180⁰ entgegengesetzter Spannungsversorgung herangezogen werden. 3.) Zur Ermittlung der Transistoranschlüsse sind aufwendige manuelle Schalterbetätigungen mit den Schaltern (4,5,6) nach einem aufgezeichneten "Plan" zwingend vorgeschrieben, denn 3 Schalter erlauben 8 Schalterkombinationen. 4.) Im besonderem Maße störend gestaltet sich die Tatsache, daß zur Einstellung einer der 8 Schalterkombinationen alle bestehenden Meßkabelverbindungen zwischen dem Prüfling und der gegebenen Prüfanordnung gelöst werden müssen denn 5.) führt die Einstellung einer nicht korrekten Schalterkombination sofort und unweigerlich zur Zerstörung der Basis-Emitter-Strecke(!) des zu überprüfenden Halbleiterbauelements, da kein Basiswiderstand vorgesehen ist. 6.) Da eine der 8 möglichen Schalter-Kombinationen sowieso zur sofortigen Zerstörung des zu überprüfenden Transistors nach Anschluß an der Prüfanordnung führen würde (die falsche Schalterkombination ist zuvor nicht bekannt), müssen abgesehen davon 7.) mehrere Minuten zur Durchführung einer einzigen Transistorüberprüfung angesetzt werden, wobei sich 8.) die Prüfzeit mindestens verdoppelt, wenn entsprechend Pkt. 2.) eine andere Prüfanordnung herangezogen werden muß.

Die Erfindung (CH 6 07 045) ist in keinster Weise mit den hier beschriebenen Erfindungen in Verbindung zu setzen, da es sich um ein Verfahren zum Prüfen von Dioden sowie ein Diodenprüfgerät zur Ausführung des Verfahrens handelt.

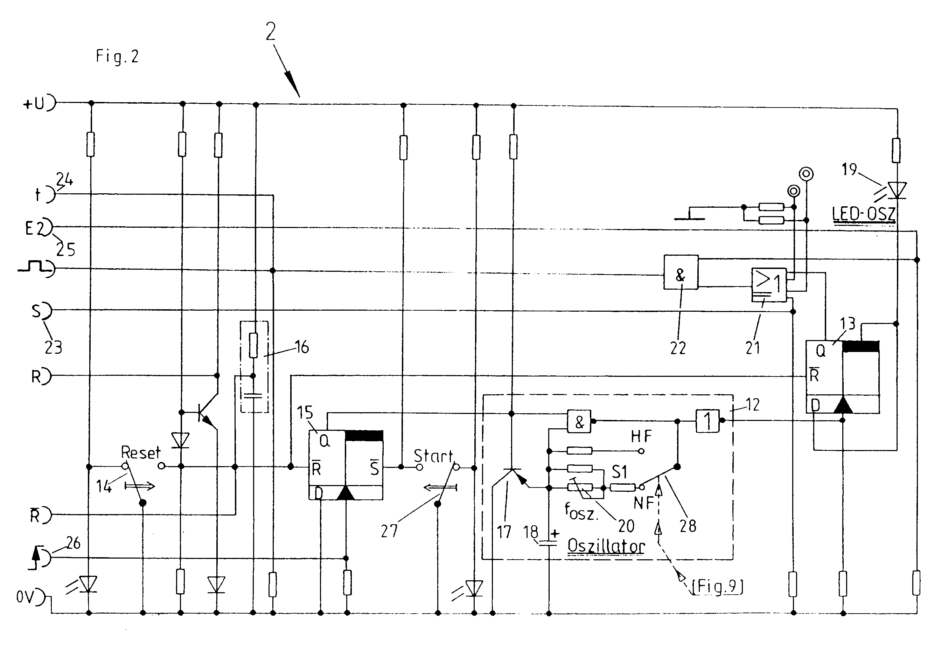

Beim Transistorprüfgerät (US 36 01 698) bezieht sich die Erfindung allein auf die Anschlußerkennung von bipolaren Transistoren und ferner erlaubt die Erfindung die Ermittlung der Kathoden-Anoden-Anschlüsse von Dioden. So erlaubt die unvorteilhafte Gestaltung der Schaltung nur unter Einsatz eines hohen Zeitaufwandes die Ermittlung der Transistoranschlüsse, wobei dies in der Weise erfolgt, daß einerseits die zu überprüfenden Transistoren zuerst aus der zu überprüfenden Schaltung auszulöten sind und darüber hinaus solange manuell von Hand entsprechend ihrer Bauform in den dafür vorgesehenen Transistorfassungen Fig.2 (30) umgesteckt werden müssen, bis die Kollektor-Emitter-Strecken eines der Transistorpaare Fig.2 (38, 40) für PNP-Transistoren oder Fig.2 (34, 36) für NPN-Transistoren Niederohmigkeit aufweisen und entsprechende Leuchtanzeigen Fig.2 (42, 44) bzw. Fig.2 (46, 48) aufhellen lassen, womit die Prüfung beendet ist. Abgesehen von Fehldiagnosen, welche weitere beträchtliche Zeitverluste nach sich ziehen (Ausbau intakter Transistoren usw.) führen Fehlersuchaktionen an elektronischen Baugruppen und deren Schaltungen allein auf vagem Verdacht hin, nicht selten zur Qualitätsminderung des Gerätes selber. So sind nach einem aufwendigem Ausbau des nur zu überprüfenden Transistors die mechanischen Belastungen der Transistoranschlüsse so groß, daß nicht selten durch mehrmaliges Anpassen der Transistoranschlüsse in den Mehrpolfassungen, diese vom Bauelement Transistor abbrechen, womit Abstand von einer fehlerfreien Serviceleistung genommen wird.

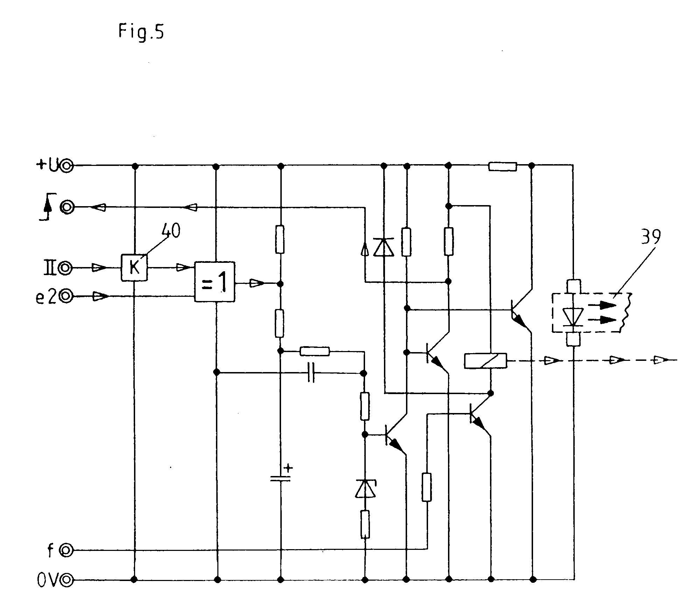

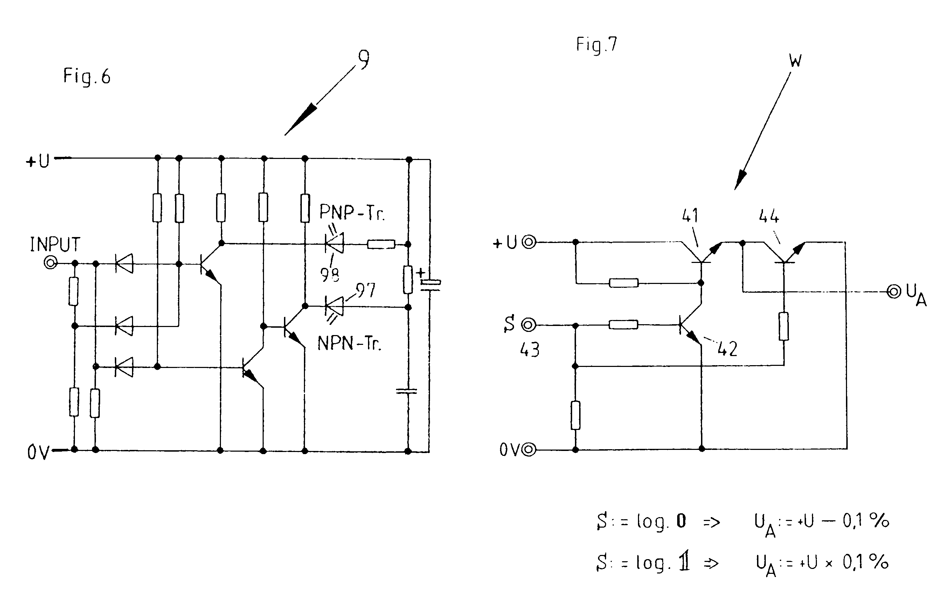

Bei einem Halbleiterprüfgerät (EP 00 48 324 A1) sind 6 Prüfanordnungen zum Prüfen verschiedener aktiver Halbleiterbauelemente vorgesehen, womit auch Transistoren überprüft werden können. Mit dem Aufbau der Erfindung sind jedoch hinsichtlich des Einsatzgebietes gänzlich andere Ziele verfolgt worden, sodaß diese Arbeit nicht als eine direkte Entgegenhaltung verstanden wird. Nachteil dieser Erfindung ist, daß über eine Mehrpolfassung die zu überprüfenden Transistoren solange manuell von Hand umgesteckt werden müssen, bis die Prüfanordnung (Fig.5, Fig.6) die Funktion des Transistors anzeigt. Diesbezüglich sind dann noch nicht einmal die Transistoranschlüsse bekannt und eine Fehldiagnose ist dadurch vorprogrammiert, daß eine schlechte Kontaktgebung des zu überprüfenden Transistors in der Mehrpolfassung nicht von einem Transistordurchbruch zu unterscheiden ist, womit im Endeffekt nicht definitiv Klarheit darüber besteht, ob der Prüfling defekt ist oder nicht. Auch hier führen mechanische Belastungen der Transistoranschlüse nicht selten zum Bruch der Anschlüsse selber, was in erheblichen Fällen zur Qualitätsminderung einer zu überprüfenden Anlage führt. Darüber hinaus leisten manuelle Schalterbedienungen keinen Beitrag zur Zeitersparnis und folglich zur Servicefreundlichkeit bei.

Die Erfindung (DD 94 435) beinhaltet eine Schaltungsanordnung die es ermöglicht, die Anschlußbelegung von Transistoren zu erkennen, wobei die Herausfindung der Transistoranschlüsse durch ständiges manuelle Umstecken des Transistors in der dafür vorgesehenen Mehrpolfassung SEITE-8- (7) erreicht wird. Abgesehen vom zeitaufwendigem Überprüfverfahren, zu dessen Durchführung der Prüfling zuvor aus der zu überprüfenden Schaltungseinheit herausgelötet werden muß, wartet diese Erfindung mit nachstehenden unvorteilhaften Ausgestaltungen auf: Durch das in diesem Überprüfverfahren ständig erforderliche Umstecken des Transistors manuell von Hand in der dafür vorgesehenen Mehrpolfassung, sind die mechanischen Belastungen der Transistoranschlüsse so groß, daß diese nicht selten vor Abschluß einer Überprüfung einen Bruch erleiden. Darüber hinaus äußert sich eine schlechte Kontaktgebung des Transistors in der Mehrpolfassung in der gleichen Weise wie ein Transistor mit einem internen Durchbruch, wodurch mit dieser Prüfanordnung nicht definitiv Klarheit darüber geschaffen werden kann, ob der Transistor defekt ist.

Beim Transistorprüfgerät (US 41 17 400) kann der zu überprüfende Transistor einerseits über eine Transistorfassung Fig.3 (12) als auch anderseits über Prüfspitzen und den Eingangsbuchsen Fig.3 (8a, 8b, 8c) mit der Prüfanordnung verbunden werden. Dabei werden über einen Dreieben-Stufenschalter Fig.3 (18-1, 18-2, 18-3) mit den sechs gegebenen Schalterstellungen manuell über den Wählschalter "Test" Fig.1 (18) die sechs möglichen Anschlußkombinationen des zu überprüfenden Transistors mit der Prüfanordnung schrittweise hergestellt. Nach ergebnislosem Prüfdurchgang wird über den Funktionsschalter Fig.1 (32) in der Schalterstellung 31b die Einheit Fig.2 (87) zur Ansteuerung des Motors Fig.2 (89) in der Weise beeinflußt, sodaß der Motor (89) den mit seiner Drehachse verbundenen Sechseben-Stufenschalter in der Art beeinflußt, sodaß die sechs Schalter Fig.3 (32a, 32b, 32c, 32d, 32e, 32f) umgelegt werden, womit die Prüfanordnung von beispielsweise einer PNP-Transistorüberprüfung zu einer NPN-Transistorüberprüfung wechselt. Nach Rückstellung des Wählschalters "Test" Fig.1 (18) in Ausgangsposition, können erneut die sechs möglichen Anschlußkombinationen des zu überprüfenden Transistors mit der Prüfanordnung manuell schrittweise mit dem Dreiebenschalter Fig.3 (18) durchgeschaltet werden. Über den Anzeigefeldern Fig.1 (20) wird die Auskunft über die Anschlußbelegung des Transistors gegeben. Um welch einen Transistortyp es sich handelt (NPN- oder PNP-Transistor) wird mit den Leuchtanzeigen Fig.1 (20) mitgeteilt. Über den Leuchtanzeigen Fig.1 (28) erhält man Auskunft über das Halbleitermaterial (Silizium oder Germanium). Ob der zu überprüfende Transistor bei einer "Null-Funktion" in der letzten Schalterstellung des Wählschalters (18) letztendlich defekt ist, oder ob die "Null-Funktion" der Prüfanordnung auf eine schlechte Kontaktgebung des Prüflings in der Prüffassung zurückzuführen ist, bleibt zum guten Schluß ohne Hinzunahme weiterer Meßgeräte ein großes Fragezeichen. Weitere unvorteilhafte Ausgestaltungen der Erfindung sind die unerläßlichen manuelle Schalterbedienungen zur Durchführung der machbaren Überprüfungen. Abgesehen von den Störanfälligkeiten der mechanischen Mehrebenschalter und den Wartungsarbeiten, welche eine Folge schlechter Kontaktgebung bei Dauerbelastung an Motor (89) und mechanischen Schaltern zwingend werden, wirken die vom Elektromotor (89) ausgehenden Impulsspitzen störend auf die eigentliche Erfindung.

So beinhaltet die Erfindung (US 34 78 264) drei Prüfschaltungen, wobei die Prüfanordnung für Transistoren sich auf ein manuelles Umstecken des zu prüfenden Transistors in einer Mehrpolfassung beschränkt. Zeigt das Meßwerk Fig.2 (93) einen Zeigerausschlag, so kann unter Hinzunahme des Ergebnisses vom Meßwerk Fig.2 (84) der Stromverstärkungsfaktor errechnet werden. Mit dieser Erfindung ist gänzlich ein ganz anderes Ziel verfolgt worden.

Aufgabe der Erfindung ist es, ein Transistormeßgerät der eingangs beschriebenen Gattung im Hinblick auf Zuverlässigkeit, Schnelligkeit, leichter Bedienbarkeit und insbesondere des Meßumfanges in sofern zu verbessern, sodaß ein Meßgerät der Art geschaffen wird, welches auf jedem Teilgebiet der Elektronik Einsatz findet. Darüber hinaus wurde die in der Elektronik "junge Technologie" der SMD-Technik in sofern berücksichtigt, daß es dem Techniker ermöglicht wird, über nur einem Meßkabel die in den Schaltungen schwer zugänglichen SMD-Transistoren auf ihre korrekte Funktion hin zu überprüfen. Das gesamte Transistormeßgerät kann erstmals einerseits absolut kontaktlos oder wahlweise mit in der Schaltung befindlichen Relais (= nicht kontaktlos) aufgebaut werden, womit die gesamte Elektronik des Transistormeßgerätes als LSI-Baustein herstellbar wird. Diese Aufgabe wird gelöst mit den Merkmalskombinationen, die den Ansprüchen zu entnehmen sind. Vorteilhafte Ausgestaltungen ergebeben sich aus den Unteransprüchen und der Beschreibung.

Im folgenden wird ein in der Zeichnung dargestelltes Ausführungsbeispiel der Erfindung erläutert; es zeigen:
- Fig. 1: schematisch ein Blockschaltbild des Transistormeßgerätes,
- Fig. 2: das Schaltbild einer Start/Stop-Einrichtung,
- Fig. 3: das Schaltbild einer Umsetzbaugruppe,
- Fig. 4: das Schaltbild eines Moduls "A" mit Relaiskarte,
- Fig. 5: das Schaltbild einer NPN-PNP-Auswertlogik,
- Fig. 6: das Schaltbild einer NPN-PNP-Anzeige,
- Fig. 7: das Schaltbild eines vollelektronischen Relais zum Umsetzen einer binären Information in eine einem Transistoranschluß zuführende Spannung,
- Fig. 8: eine Präzisionsschaltung für einen Komparator,
- Fig. 9: das Schaltbild einer NF/HF-Umschalt- und Anzeigelogik,
- Fig. 10: das Schaltbild eines Silizium-Germanium-Detektors,

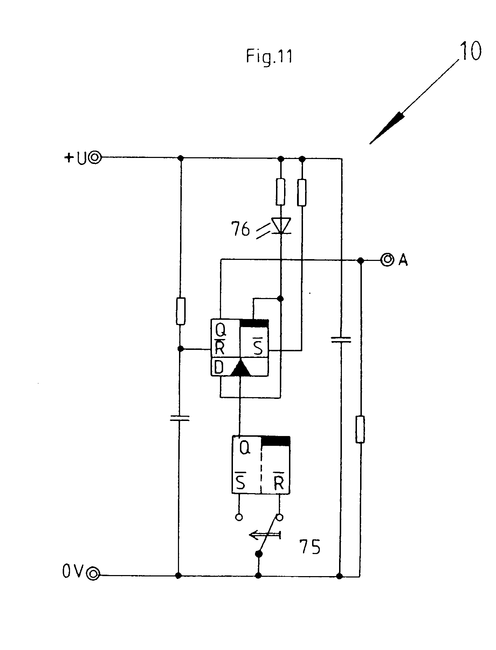

- Fig. 11: das Schaltbild eines Takt-Simulators,
- Fig. 12: das Schaltbild eines Schaltzeitmeßgerätes,
- Fig. 13: die Schaltung des diskret aufgebauten lichtgesteuerten- und kontaktlosen AC/DC-Umschalters,
- Fig. 14: das Schaltzeichen des lichtgesteuerten- und kontaktlosen (= vollelektronischen) AC/DC-Umschalters,
- Fig. 15: das Schaltbild eines vollelektronischen und kontaktlosen Relais,
- Fig. 16: das Schaltzeichen/Schaltsymbol des vollelektronischen und kontaktlosen Relais,

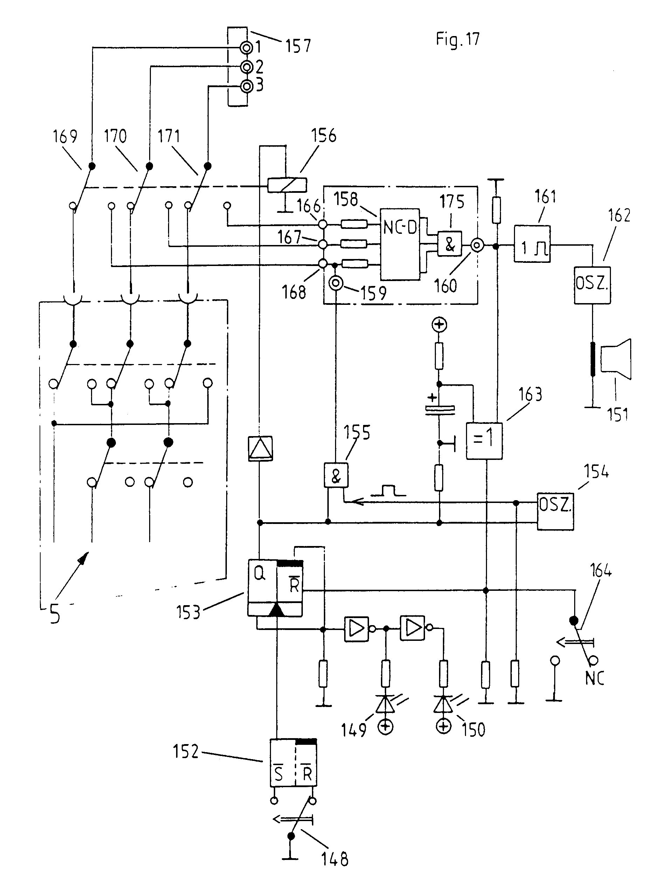

- Fig. 17: das Schaltbild zur digitalen Anzeige der korrekten Kontaktgebung des Transistors mit der Meßelektronik,
- Fig. 18: die Schaltung des NC-Dekoders,

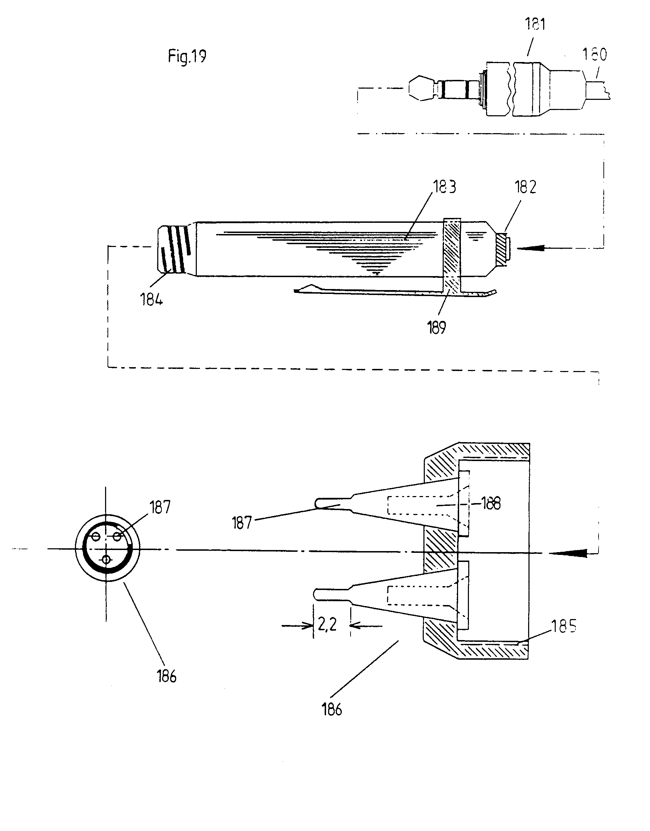

- Fig. 19: die techn. Zeichnung vom SMD-Bauteilprüfstift,
Die Suchlaufeinrichtung weist einen Oszillator 12 mit einem nachgeschalteten Binärzähler 29 auf, wobei die Ausgänge des Binärzählers 29 einerseits über Binär/Dezimal-Wandler 30, 31 die Anzeigen 8 und außerdem Relais 34 zum Umschalten der Transistoranschlüsse betätigen sowie anderseits über Pegelwandler 35 zu den Kontakten der die Transistoranschlüsse versorgenden Relais 34 geführt sind, und daß ein Komparator 40 vorgesehen ist, der den Oszillator 12 abschaltet, wenn am Kollektor des untersuchten Transistors ein bestimmter Spannungsabfall auftritt. Auch mit diesem Transistormeßgerät können Transistoren sowohl in eingebautem als auch in ausgebautem Zustand untersucht werden. Im Rahmen der beschriebenen Schaltung werden nacheinander die Transistoranschlüsse (Basis, Emitter, Kollektor) in den möglichen Kombinationen mit Spannung versorgt, wobei maximal 16 Schaltstufen (= Vier-Bit-Binärcode) durchlaufen werden. Erst wenn am Kollektor des untersuchten Transistors unter Berücksichtigung des Transistortyps ein bestimmter Spannungsabfall auftritt, schaltet der Komparator 40 den Oszillator 12 aus und entsprechende, vorzugsweise optische Anzeigen 8 ein bzw. läßt Anzeigen 8, 97, 98, die zu jeder Zeit die Tiefe der schon durchgeführten Prüfschritte erkennen lassen, weiter aufleuchten, aus denen die Transistoranschlüsse und die Halbleiterdotierungsfolge NPN- oder PNP-Transistor entnommen werden können. Da das erfindungsgemäße Transistorprüfgerät vollelektronisch arbeitet, ist es praktisch verschleiß- und damit wartungsfrei und läßt sich ferner in praktisch beliebigen Abmessungen aufbauen.

Das in der Zeichnung dargestellte Transistormeßgerät besteht in seinem grundsätzlichen Aufbau aus einem Netzteil 1, einer Start/Stop-Einrichtung 2, einer Umsetzbaugruppe 3, einem Modul "A" 4, einer Relaiskarte 5, einer NF/HF-Umschalt- und Anzeige- logik 6, einem Schaltzeitmeßgerät 7, einer Anzeige für Belegung der Transistoranschlüs-se 8, einer Anzeige für Dotierungsfolge: NPN/PNP 9, Taktsimulator mit Anzeige 10 und dem +U_{BE}/-U_{EB}-mV-Spannungsmesser 11.

Dem Oszillator 12 ist ein Delay-Flipflop 13 zur Realisierung eines Tastverhältnisses von 1:1 nachgeschaltet, wodurch der Binärzähler 29 stets mit einem symmetrischem Signal angesteuert wird.

Ferner ist eine Reset-Taste 14 beim Delay-Flipflop 15 vorgesehen, über der alle an ihr angeschlossenen Speicherbausteine in einer geordneten Ausgangssituation versetzt werden.

Die bevorzugte Schaltung ist außerdem mit einer RC-Kombination 16 vorgesehen, dessen Knotenpunkt mit dem Setz/Rücksetz-Kontakt der Reset-Taste 14 in unlösbarer Verbindung steht. Dadurch versetzen sich alle an ihr angeschlossenen Speicherbausteine mit der Inbetriebnahme des Transistormeßgerätes selbstätig und ohne äußeres Hinzutun in einer geordneten Ausgangssituation, sodaß vor der 1. Messung die Reset-Taste 14 nicht betätigt werden muß.

Ferner ist ein Entlade-Schalt-Transistor 17 im Oszillatorkreis 12 vorgesehen. Durch diesen Transistor 17 wird sichergestellt, daß der Kondensator 18 im Oszillatorkreis 12 im inaktiven Zustand des Oszillators absolut entladen wird. Die daraus resultierenden Vorteile sind folgende:
1. Jede Messung wird präzise mit einer positive ansteigenden Taktflanke am Binärzähler 29 eingeleitet.
2. Die 1. Meßzeit ist gleichlang wie die darauffolgenden Meßzeiten.
3. Wird der Oszillator 12 vom Übertragssignal "CY" vom Binärzähler 29 kommend gestoppt, stellt sich ein Dauerleuchten der Oszillatoranzeige 19 ein, womit die Oszillatoranzeige 19 fünf Anzeigefünktionen übernimmt:
   3.1 Während der Prüfvorgänge im Oszillatorbetrieb teilt die aktive Oszillatoranzeige 19 mit, daß eine aktive Spannungsmessung um den Prüfling Transistor im Gange ist.
   3.2 Im inaktivem Zustand der Oszillatoranzeige 19 im Oszillatorbetrieb, wird die selbstätige Umrüstung des Transistormeßgerätes auf den nächst tieferen Prüfschritt mitgeteilt.
   3.3 Mit Abschluß einer Einzelmessung in der Betriebsart "Niederfrequenz-Transistor-Überprüfüng" teilt die ständig aufleuchtende Oszillatoranzeige 19 definitiv mit, daß der NF-Transistor defekt ist.
   3.4 Mit Abschluß einer Einzelmessung in der Betriebsart "Niederfrequenz-Transistor-Überprüfung" im Oszillatorbetrieb wird die Bereitschaft für eine "HF-Tran-sistor-Einzelmessung" mitgeteilt. Dies mit der Aufforderung, die Start-Taste 27 ein-mal zu betätigen.
   3.5 In der Betriebsart "Schrittmessung" wird die Oszillatoranzeige 19 von der Simulationsanzeige 76 abgelöst und die während des Betriebes inaktive Oszillatoranzeige 19 teilt die korrekte Funktion der Betriebsart mit.

Ferner ist ein Potentiometer 20 im Oszillatorkreis 12 vorgesehen, womit vor einer NF-Transistor-Überprüfung die Oszillatorfrequenz f_{OSZ.} innerhalb eines gegebenen Bereiches frei einstellbar ist.

Außerdem ist ein Oder-Gatter 21 mit vier Eingängen vorgesehen, über der
1. die symmetrische Taktfrequenz unverfälscht über ein Und-Gatter 22 zum Binärzähler 29 gelangt
2. dessen zweiter Eingang steht in direkter Verbindung mit dem Ausgang des Simulators
3. dessen dritter Eingang steht in direkter Verbindung mit einer BNC-Ausgangsbuchse zwecks Anschlusses eines externen, kabelgebundenen Simulators
4. dessen vierter Eingang zum Anschluß einer kabellosen Fernbedienung dient, zwecks Simulation der Oszillatorfrequenz resp. der Taktfrequenz in der Betriebs-art "Einzelschrittmessung".

Ferner findet eine Abzweigung vom Und-Gatter 22 zur Ausgangsbuchse "t" statt, die in direkter Verbindung mit dem Eingang eines Schaltzeitmeßgerätes steht und über der die zu messenden Signale für Meßbeginn und Meßende geführt werden.

Außerdem befindet sich im Oszillator 12 der Schalter 28 vom Relais 53 zur Änderung der Oszillatorfrequenz, wodurch von einer Niedertrequenz-Transistor-Prüfung auf eine Hochfrequenz-Transistor-Prüfung geschaltet werden kann, sodaß mit dem Tran-sistormeßgerät sowohl NF-Transistoren als auch HF-Transistoren untersucht werden können.

Eine weitere bevorzugte Ausführung der Erfindung ist dadurch gekennzeichnet, daß dem Komparator 40 ein Silizium-Germanium-Detektor nachgeschaltet ist, der einen Opto-koppler 39 und einen Impedanzwandler 99 aufweist, wobei der Impedanzwandler eine duale Spannungsversorgung und einen niederohmigen Ausgang aufweist und der Ausgang einerseits niederohmig über einen Germanium-Transistor 100 und eine an dessen Emitter angeschlossene Silizium-Diode 101 an der Bezugsspannung sowie anderseits an Anzeigen für "Silizium" 102 bzw. "Germanium" 103 anliegt. Damit kann das Transistormeßgerät auch selbstätig und ohne äußeres Hinzutun feststellen, aus welchem Halbleiterausgangsdotierungsmaterial der zu untersuchende Transistor hergestellt ist.

Bei der bevorzugten Schaltung wird die Ausgangsspannung eines Festspannungsregler -IC 104 durch Anhebung des Bezugspotentials unter Hinzunahme einer Zener-Diode 105 mittels eines Potentiometers 106 in gewünschter Höhe möglich.

Außerdem wird diese Ausgangsspannung dem Pluseingang eines vollelektronischen Relais 107 zugeführt, welcher die geregelte Plusspannung erst dann zu seinem Ausgang durchschaltet, wenn der Steuereingang "S" 108 vom vollelektronischem Relais 107 durch den angesteuerten Optokoppler 39 über der Kollektor-Emitter-Strecke des Optokopplers auf Bezugspotential liegt. Erst dann liegt am dualen Spannungsteiler 109, dem Impedanzwandler 99 und den Silizium-Germanium-Leuchtanzeigen 102 oder 103 die für ihren Betrieb erforderliche Betriebsspannung an, aus welchen Gründen die Leuchtanzeigen 102 oder 103 sich erst nach Abschluß einer Transistorüberprüfung von der aktiven Seite her zeigen.

Ferner wird die relativ hochohmige +U_{BE}-Spannung bei NPN-Transistoren und die ebenfalls relativ hochohmige -U_{EB}-Spannung bei PNP-Transistoren über eine Relais-Schaltung 110 immer mit der korrekten Polarität dem sehr hochohmigen Eingang des als Impedanzwandler geschalteten Operationsverstärker 99 zugeführt, wodurch die Basis/Emitter-Spannungen stets mit der gewünschten Polung und unverfälscht und niederohmig am Ausgang des Impedanzwandlers 99 zur Verfügung steht.

Eine weitere vorteilhafte Ausgestaltung ist mit dem niederohmigen Ausgangswiderstand des Impedanzwandlers 99 dadurch gegeben, daß zwischen ihm und dem virtuellen Nullpunkt 111 der Schaltung sogar recht niederohmige analoge Meßwerke zur Spannungsanzeige mit nur einem Richtungsausschlag geschaltet werden können. Im Zuge der Genauigkeit ist bei der bevorzugten Schaltung ein digitales mV-Meter 11 zwischen den besagten Meßpunkten geschaltet, womit charakteristische Spannungsschwankungen unter gleichnamigen Transistortypen von vornherein z.B. für Meßzwecke selektiert werden können.

Außerdem steuert die Ausgangsspannung des Impedanzwandlers die als vollelektonisches Relais geschalteten Transistoren 112, 113 an, an dessen Ausgang die Leuchtan-zeigen für "Silizium" 102 und "Germanium" 103 geschaltet sind.

Ferner ist zur direkten Anssteuerung des vollelektronischen Relais 107 ein Optokoppler 39 vorgesehen, der eine Signalübertragung zwischen den elektrisch isolierten Stromkreisen mit unterschiedlichen Spannungspegeln ermöglicht, womit einerseits keine elektrische und anderseits eine kontaktlose Verbindung zwischen zwei Schaltungen mit unterschiedlichen Spannungspotentialen geschaffen wurde.

Eine weitere bevorzugte Ausführung der Erfindung ist dadurch gekennzeichnet, daß das Übertragsausgangs-Signal "CY" vom Binärzähler 29 kommend zur gesamten Steuerung der NF/HF-Umschalt- und Anzeigelogik herangezogen wird. Dies ist dadurch möglich, da das Übertragsausgangs-Signal "CY" über eine Eingangsbuchse 45 und einem Exor-Gatter 46 die vier an einer Taktleitung 47 liegenden Delay-Flipflops 48 zeitgleich taktet, womit die an den jeweiligen Dateneingängen anliegenden Informationen einerseits für die optischen Anzeigen "Niederfrequenztransistorüberprüfung" 49, "Hochfrequenztransistorüberprüfung" 50, "Transistor defekt" 51, "Messung abgeschlossen" 52 und anderseits zur Ansteuerung eines Relais 53 zur NF/HF-Umschaltung zu den jeweiligen Q-Ausgängen der Delay-Flipflops 48 selber durchgeschaltet werden.

Die Ausrichtung der gesamten Schaltung erfolgt über der Eingangsbuchse 54, womit die gesamte Logik für eine "Vollmessung" vorbereitet ist, was durch die optische Leuchtanzeige "Vollmessung" 55 mitgeteilt wird. Die ferner dann noch aufleuchtende Leuchtanzeige 49 "Niederfrequenz-Transistor-Prüfung" verlischt erst dann, nachdem die letzte Niederfrequenz-Transistor-Überprüfung den Abschluß gefünden hat. Dannach °
erscheint vom Binärzähler 29 kommend das Übertragssignal "CY", taktet die vier Delayflipflops 48, läßt die Leuchtanzeige 50 "HF-Transistorüberprüfung" aufhellen, läßt zeitgleich über eine Transistorstufe 56 ein Relais 53 anziehen, wodurch zwei Schalter 28,37 umgelegt werden, die einerseits eine Veränderung der Oszillator-frequenz und anderseits die Zwischenschaltung eines anderen Meßwiderstandes 36 in der Transistorprüfschaltung zur Folge haben. Ohne äußeres Hinzutun wird die HF-Transistor-Überprüfüng fortgesetzt, da ein mit einem Oder-Gatter 57 am Ausgang der Gesamtlogik befindliches Und-Gatter 58, das von einem am Ausgang der Logik befindliche retriggerbaren Monoflops 59 produzierte Ausgangssignal, nicht am Ausgang 60 der Schaltung erscheinen läßt, wodurch der Oszillator 12 nicht gestoppt wird. Die Leuchtanzeige 50 "HF-Transistor-Überprüfung" verlischt erst dann, nachdem die letzte HF-Transistorüberprüfung ihren Abschluß gefunden hat. Das dann erscheinende Übertragssignal "CY" bewirkt zeitgleich die Aktivierung der Leuchtanzeige 51 "Tran-sistor defekt" und das Abfallen des zuvor angezogenen Relais 53, als auch einerseits die Taktung eines Delayflipflops 61, welches die Leuchtanzeige 52 "Messung ab-geschlossen" aufleuchten läßt und von dessen Q-Ausgang ferner über eines am Ausgang der Logik beflndliches Oder-Gatter 57 ein log.0-Signal zur Verrieglung der Start/Stop-Einrichtung ausgeht als auch anderseits die Taktung eines in der Start/Stop-Einrichtung befindlichen Delay-Flipflop 15, wodurch der Oszillator gestoppt wird. Die verbleibende Einflußmöglichkeit auf der Schaltung ist während eines Prüfvorganges eines NF- oder HF-Transistors möglich, wenn von der Auswertlogik das Stop-Signal über ein Oder-Gatter 62 auf den Takteingang des darauffolgenden Delay-Flipflops 61 erfolgt, worauf die Leuchtanzeige 52 "Messung abgeschlossen" aufhellt und das an seinem Q-Ausgang erscheinende log.0-Signal für eine Verrieglung über eine Tor-Schaltung 22 in der Start/Stop-Einrichtung sorgt, wodurch die Oszillatorfrequenz °
keinen Einfluß auf den Binärzähler 29 nehmen kann. Ferner gelangt das Stop-Signal über den Eingang einer darauffolgenden Oder-Schaltung 57 zum Ausgang 60 der Schaltung, wodurch der Oszillator 12 in der Start/Stop-Einrichtung sofort angehalten wird. Somit ist mit der Schaltung eine "Vollmessung" durchführbar, mit der zuerst eine NF-Transistorüberprüfung erfolgt und die nahtlos nach dem ersten Prüf-Intervall zur HF-Transistorüberprüfung wechselt, ohne das zu diesem Zweck Einfluß auf die Schaltung genommen werden muß. Dabei zeigt sie die Art der Transistorprüfung, NF/HF-Transistorüberprüfung über optische Anzeigen 49, 50 an und teilt ferner über Leuchtanzeigen 51, 52 an, ob der Prüfling Transistor defekt ist und wann die Messungen abgeschlossen sind. Eine gesonderte Stellung nimmt dabei die oben beschriebene Meßart und die dazugehörende optische Anzeige 55 für eine Vollmessung ein, denn die bevorzugte Schaltung erlaubt die exteme Beeinflussung auf den Programmablauf, womit neben der Vollmessung auch Einzelmessungen und die Kombination von "Schrittüberprüfungen" in der Meßart Vollmessung und Einzelmessungen machbar sind.

Zur Durchführung einer Einzelmessung zur Realisierung einer alleinigen HF-Transistor-Überprüfung sind in der bevorzugten Schaltung der CY-Simulator 63, das daran angeschlossene RS-Kippglied 64, eine am Q-Ausgang des genannten RS-Kippgliedes 64 angeschlossene R-D-R-Kombination 65 sowie die Digit-Taste 66 für die Wahl einer HF-Transistorüberprüfung vorgesehen. Dabei wird nach Betätigung der Reset-Taste 14 die Taste 66 "HF-Transistor-Überprüfung" einmal betätigt und über das RS-Kippglied 64 und dem daran angeschlossenen Delay-Flipflop das retriggerbare Monoflop 68 getriggert, an dessen Ausgang das simulierte CY-Signal über das ange-°
schlossene Exor-Gatter 46 Einfluß auf die an der Taktleitung 47 angeschlossenen Delay-Flipflops 48 nimmt, womit von der NF- auf die HF-Transistor-Überprüfung geschaltet wurde. Mit Betätigung der Taste 66 "HF-Transistor-Überprüfung" erscheint am Q-Ausgang des RS-Kippgliedes 64 kurzzeitig ein prellfreier Impuls, welcher ferner über ein R-D-R-Glied 65 das für die optische Leuchtanzeige 55 "Vollmessung" verantwortliche Delay-Flipflop 69 taktet, wodurch sich einerseits die Anzeige 55 "Vollmessung" verdunkelt und anderseits sein Q-Ausgang log. 1-Pegel annimmt, womit das am Q-Ausgang angeschlossene Und-Gatter 58 in der Weise vorbereitet ist, daß ein vom Monoflop 59 kommendes Signal, dessen Ausgang in Verbindung mit dem verbleibenden Und-Gatter-Ausgang 58 steht, über das Und-Gatter 58 gelangen kann, womit der Oszillator 12 nach Abschluß der letzten HF-Transistor-Überprüfung gestoppt wird.

Somit ist nach Betätigung der Reset-Taste 14 und der Taste 66 "HF-Transistor-Überprüfung" eine Einzelmessung zur Überprüfung von Hochfrequenz-Transistoren möglich, womit die NF-Transistor-Überprüfungsschritte umgangen wären. Das es sich nicht um eine "Vollmessung" handelt, ist augenscheinlich an der inaktiven Leuchtanzeige 55 "Vollmessung" erkennbar. Die Art der gewählten Einzelprüfung ist optisch an der aktiven Leuchtanzeige 50 "HF-Transistor-Überprüfung" erkennbar.

Zur Durchführung einer Einzelmessung zur Realisierung einer alleinigen NF-Transistor-Überprüfung sind in der bevorzugten Schaltung die Taste 70 "NF-Transistor-Überprüfung", das daran angeschlossene RS-Kippglied 71, das Delay-Flipflop 69, welches für die Leuchtanzeige "Vollmessung" zuständig ist sowie das am Q-Ausgang des besagten Delay-Flipflop 69 angeschlossene Und-Gatter 58 vorgesehen. Dabei wird nach Betätigung der Reset-Taste 14 die Taste 70 "NF-Transistor-Überprüfung" einmal betätigt, wonach ein prellfreier Impuls vom RS-Kippglied 71, das Delay-Flipflop 69 taktet. Dabei verlischt die optische Leuchtanzeige 55 "Vollmessung" und am Und-Gatter-Eingang 58 liegt ein log. 1-Pegel an. Gelangt nach Ablauf der Niederfrequenz-Transistor-Überprüfung das vom Binärzähler 29 ausgesandte CY-Signal über das Exor-Gatter 46 auf den gemeinsamen Takteingang 47 der vier Delay-Flipflops 48, erscheint am Ausgang der Schaltung zur Signalumwandlung 73 resp. am Ausgang des retriggerbaren Monoflops 59 ein simuliertes Stop-Signsal, welches ungehindert über das Und-Gatter 58 und das Oder-Gatter 57 zur Start/Stop-Einrichtung gelangt, womit der Oszillator 12 indirekt gestoppt wird. Somit ist nach Betätigung der Reset-Taste 14 und der Taste 70 "NF-Transistor-Überprüfung" eine Einzelmessung zur Überprüfung von Niederfrequenz-Transistoren möglich, wobei gegenüber der "Vollmessung" die HF-Transistorüberprüfung nicht mehr durchgeführt wird. Zwar richtet sich die Meßelektronik auf eine anschließende HF-Transistor-Überprüfung ein, aber diese kann nur über eine erneute Betätigung der Start-Stop-Taste 27 eingeleitet werden, was über der ständig aufleuchtenden Oszillatoranzeige 19 mitgeteilt wird.

Im Eingangskreis ist ein Exklusiv-Oder-Gatter 46 vorgesehen, welches einerseits die Zuführung des vom Binärzähler 29 kommenden Signals als auch das vom CY-Simulator 63 kommenden Signals auf die Taktleitung 47 erlaubt und anderseits eine Wandlerfunktion übernimmt, wodurch mit zwei unterschiedlich aussehenden Signalen die am Ausgang vom Exor-Gatter angeschlossenen Delay-Flipflops 48 getaktet werden können.

Ferner ist ein CY-Simulator 63 vorgesehen, welcher in Verbindung mit dem an der Ausgangsleitung angeschlossenen Exklusiv-Oder-Gatter 46 die Nachbildung des vom Binärzählers 29 kommenden CY-Signals erlaubt, womit mit der am Eingang der Schaltung liegenden Taste 66 "HF-Transistor-Überprüfung" Einfluß auf den vorprogrammierten Programmablauf genommen werden kann. Dabei arbeitet die Schaltung in der Weise, daß nach Betätigung der Eingangstaste 66 "HF-Transistor-Überprüfung" das RS-Flipflop 64 ausgangsseitig einen prellfreien Impuls auf den Takteingang des Delay-Flipflop 67 weiterleitet, womit der Q-Ausgang log. 1-Pegel annimmt und das retriggerbare Monoflop 68 triggert, womit einerseits das Exor-Gatter 64 mit einem log. 1-Signal angesteuert wird und anderseits ein am Monoflop-Ausgang angeschlossener Inverter 72 das Signal um 180⁰-Grad dreht, womit das Delay-Flipflop 67 selbstätig zurückgesetzt wird und sich die Schaltung des CY-Simulators 63 in Ausgangssituation befindet. Somit kann das nachgebildete Monoflop-Signal auch tatsächlich nur für die berechnete Zeit bzw. der Monoflopzeit wirksam sein.

Außerdem beinhaltet die bevorzugte Schaltung eine Schaltungseinheit 73 zur Signalumwandlung, welche schaltungstechnisch gleich dem CY-Simulator 63 aufgebaut ist. Hierbei wird das zugehörige Delay-Flipflop 48-1 vom CY-Signal getaktet, worauf das zugehörige retriggerbare Monoflop 59 vom Q-Ausgang des Delay-Flipflop 48-1 getriggert wird, welcher einerseits mit seinem Ausgangs-Signal über ein Und-Gatter 58 und ein Oder-Gatter 57 zum Ausgang 60 geleitet wird, wodurch der Start/Stop-Oszillator 12 in der Start/Stop-Einrichtung angehalten wird und anderseits sein Ausgangs-Signal auf den nachgeschalteten Invertereingang 74 gegeben wird, womit das Delay-Flipflop 48-1 selbstätig in Ausgangssituation rückgesetzt wird. Somit findet eine Signalumwandlung von log.1-auf log.0-auf log.1 zu einem alleinigen log. 1-Signal für den Start/Stop-Oszillator 12 in der Start-Stop-Einrichtung statt.

Ferner ist eine Anzeige- und Umschaltlogik vorgesehen, die einerseits erkennen läßt, welche Art der Transistor-Prüfung sich im Ablauf befindet, NF- oder HF-Transistor-Überprüfung 49, 50 und weiter Mitteilung darüber gibt, ob ein Transistor defekt ist 51 und wann eine Messung abgeschlossen ist 52 und anderseits mit dem optischen Anzeigewechsel von NF-Transistor-Überprüfung auf HF-Transistor-Überprüfung oder umgekehrt ein Relais 53 zum Anziehen oder Abfallen schaltet, womit schaltungstechnische Veränderungen in der Transistor-Prüfschaltung durch Meßwiderstandsänderung 36- und im Start/Stop-Oszillatorkreis 12 eine Veränderung der Grundfrequenz stattfindet. Dies erfolgt dabei in der Weise, daß die an einer Taktleitung befindlichen Delay-Flipflops zeitgleich vom CY-Signal vom Binärzähler 29 kommend getaktet werden, wobei mit jedem CY-Signal die an den Dateneingängen anliegenden Binär-Informationen zu den Q-Ausgängen der Delay-Flipflops 48 durchgeschaltet werden und einerseits die optischen Leuchtanzeigen entsprechend der durchgeschalteten Information aktivieren und anderseits das Relais 53 zur NF/HF-Umschaltung anziehen oder abfallen lassen.

Außerdem ist ein "Verrieglungs-Delay-Flipflop" 61 vorgesehen, welches mit jedem Abschluß einer Messung- und insbesondere wichtig bei der Benutzung des Simulators als Taktgeber, selbstätig die Verrieglung der Start/Stop-Einrichtung durchführt, sodaß ungewollt gegebene Taktsignale nach Abschluß einer Messung, keinen Einfluß auf den Binärzähler 29 nehmen können. Dies erfolgt dabei in der Weise, daß ein Oder-Gatter 62 mit zwei Eingängen vorgesehen ist, zudem einerseits das Stop-Signal der Auswertlogik und anderseits das Signal von dem Q-Ausgang des Delay-Flipflops 48-2 geführt wird, daß für die optische Leuchtanzeige "Transistor defekt" 51 zuständig ist. Entsprechend, welches der genannten Signale zuerst an den beschriebenen Punkten erscheint, wird zum Ausgang des Oder-Gatters 62 geschaltet, wodurch das Verrieglungs-Delay-Flipflop 61 getaktet wird und das an seinem Q-Ausgang erscheinende log. 0-Signal die Start/Stop-Einrichtung verriegelt. Der Zeitpunkt der Verrieglung ist optisch an der aufhellenden Leuchtanzeige "Messung abgeschlossen" erkennbar.

Ferner sieht die bevorzugte Schaltung eine Einrichtung vor, die den Eingriff im Programmablauf in der Art und Weise erlaubt, sodaß im Gegensatz zur "Vollmessung", welche eine NF- und HF-Transistor-Prüfung vorsieht, nur eine NF-Transistor-Prüfung durchgeführt wird. Dies erfolgt dabei in der Weise, daß nach Betätigung der Digit-Taste 70 "NF-Transistor-Überprüfung" über ein RS-Kippglied 71 ein prell-freier Impuls auf den Takteingang eines danachgeschalteten Delay-Flipflops 69 gelangt, wodurch einerseits die Leuchtanzeige "Vollmessung" 55 verlischt und anderseits ein am Q-Ausgang des Delay-Flipflops 69 angeschlossener Und-Gatter-Eingang 58 mit einem log. 1-Pegel beaufschlagt wird. Eines nach Ablauf einer NF-Transistor-Überprüfung am Ausgang der Signal-Wandlerschaltung 73 erscheinende log. 1-Signal gelangt über das nachgeschaltete Und-Gatter 58 und Oder-Gatter 57 zur Start/Stop-Einrichtung, wodurch der Oszillator 12 gestoppt wird und die NF-Transistor-Überprüfung abgeschlossen ist.

Eine weitere vorteilhafte Ausgestaltung der Erfindung kennzeichnet sich dadurch aus, daß von einem Simulator aus prellfreie Impulse auf eine dafür vorgesehene Eingangsklemme "S" 23 der Start/Stop-Einrichtung gegeben werden, womit neben den Meßarten Vollmessung und Einzelmessungen auch Schritt-Überprüfungen in den Meßarten Vollmessung und Einzelmessungen durchführbar sind. Diesbezüglich gelten die schon beschriebenen Maßnahmen zur Einflußnahme auf den Ablauf des Programms, jedoch wird die Ablaufgeschwindigkeit nicht mehr vom Oszillator 12 der Start/Stop-Einrichtung vorgegeben, sondern dies kann in einer zeitlich beliebig gedehnter Form Schritt für Schritt über der Taste 75 "Simulator" bestimmt werden. Dabei wird die Oszillatoranzeige 19 durch die optische Anzeige "Simulator" abgelöst, womit sich die Simulator-Anzeige 76 mit jeder Spannungsanalyse um den Prüfling herum sich von der aktiven Seite zeigt bzw. die inaktive Simulator-Anzeige 76 den Wechsel zum nächst tieferen Prüfschritt anzeigt. Ist das Transistor-Prüfprogramm vollständig durchlaufen, wird dies durch die optische Anzeige "Messung abgeschlossen" 52 mitgeteilt, womit auch zeitgleich die Meßelektronik verriegelt wird, sodaß die weitere Betätigung der Simulationstaste ohne Auswirkung bleibt. Die Verrieglung der Start/Stop-Einrichtung und die damit verbundene Null-Funktion des Simulators ist auch dann sichergestellt, wenn während des Prüfvorganges das Stop-Signal von der Auswertlogik aus Einfluß auf die NF/HF-Umschalt- und Anzeigelogik nimmt.

Somit ist eine Schaltungseinheit geschaffen worden, wodurch eine dritte Meßart gegeben ist, die eine Schritt-für-Schritt-Überprüfung in den Meßarten Vollmessung und Einzelmessungen erlaubt. Dabei wird die Oszillatoranzeige 19 durch die optische Leuchtanzeige "Simulator" 76 abgelöst.

Eine weitere bevorzugte Ausführung der Erfindung kennzeichnet sich dadurch aus, daß das elektromagnetische Bauteil "Relais" durch eine vollelektronische- und kontaktlose Schaltung ersetzt wird. Die Realisierung erfolgt dabei in der Weise, daß der an der Basis eines Längstransistors 41 angeschlossene zweite Transistor 42 zur Steuerung des Längstransistors 41 herangezogen wird. Liegt an der Basis vom zweiten Transistor 42 ein log. 0-Pegel an, ist seine Kollektor-Emitter-Strecke hochohmig und der Längstransistor 41 bleibt durch seinen an der Basis angeschlossenen Widerstand durchgeschaltet, womit die Kollektor-Emitter-Strecke des Längstransistors 41 niederohmig bleibt. Liegt an der Basis vom zweiten Transistor 42 ein log. 1-Pegel an, ist seine Kollektor-Emmitter-Strecke niederohmig, wodurch der Längstransistor 41 gesperrt wird. Durch die Reihenschaltung der Kollektor-Emitterstrecke eines dritten Transistors 44 an den Längstransistor 41 mit Anschluß seiner Basis am Steuereingang 43, ist ein "regelbarer Widerstand" geschaffen worden, an dessen Kollektor die Ausgangsspannung abgreifbar ist. Dabei zeigen die beiden in Serie geschalteten Transistoren 41, 44 stets um 180⁰-Grad entgegengesetztes Verhalten. D.h., ist der erste Längstransistor 41 hochohmig, ist der zweite Längstransistor 44 durchgeschaltet und die Ausgangsspannung beträgt bis auf eine geringe Kollektor-Emitter-Restspannung 0-Volt. Analog dazu stellt sich am Ausgang die volle Betriebsspannung ein, ist der erste Längstransistor 41 niederohmig und der zweite Längstransistor 44 gesperrt.
Somit ist eine Schaltungseinheit entstanden, wodurch ein konventionelles "Relais" durch eine vollelektronische Schaltung abgelöst wird, welche gegenüber dem elektromechanischen Relais einerseits den Vorteil hat, kontaktlos zu sein und anderseits um ein vielfaches schneller auf Eingangssignale an seinem Ausgang reagieren zu können, wobei die Ausgangssignale noch prellfrei abgreifbar sind.

Eine weitere bevorzugte Ausführung der Erfindung kennzeichnet sich dadurch aus, daß die von einem Start/Stop-Oszillator 12 kommenden Signale nicht nur zur Ansteuerung des Binärzählers 29 herangezogen werden, sondern das diese Signale ferner über der Ausgangsbuchse "t" der Start/Stop-Einrichtung zur Meßeingangsbuchse 77 "t_{X}" der Schaltzeitmeßeinrichtung weitergeleitet werden. Dabei wird mit jeder positiv ansteigenden Taktflanke am Meßeingang 77 eine Zeitmessung in der Weise durchgeführt, daß einerseits über Oder-Gatter (I) 78 ein daran angeschlossenes Und-Gatter (I) 79 mit seinem Ausgang ein Eingang vom Und-Gatter (II) 80 mit log. 1-Pegel ansteuert, wodurch die von einem X-TAL-Oszillator 81 kommenden Impulse über das Und-Gatter (II) 80 in einen Zähler einlaufen können und anderseits zeitgleich über Oder-Gatter (I) 78 und (II) 82 ein retriggerbares Monoflop 83 getriggert wird, mit dessen Ausgangs-Signal über Oder-Gatter (III) 84 der Zähler über seinen Reset-Eingang 85 für die einlaufenden Impulse an seinem Takteingang 86 freigeschaltet wird. Erreicht vor dem Pegelwechsel von log. 1 auf log. 0 am Meßeingang 77 ein Stop-Signal der Auswertlogik den Takteingang vom Delay-Flipflop 87, geht einerseits der Q-Ausgang vom Delay-Flipflop 87 auf log. 1-Pegel, womit über das Oder-Gatter (II) 82 das retriggerbare Monoflop 83 weitergetriggert wird und den Zählerstand aufrecht erhält und anderseits wird zeitgleich das Und-Gatter (II) 80 durch den Pegelwechsel am Meßeingang 77 von log. 1 auf log. 0 undurchlässig für die vom X-Tal-Oszillator 81 kommenden Impulse. Wird das Delay-Flipflop 87 nicht getaktet, während sich an der Meßeingangsbuchse 77 das log. 1-Signal befindet, wird mit abfallendem Spannungspegel an der Eingangsbuchse 77 das retriggerbare Monoflop 83 nicht mehr getriggert, womit Oder-Gatter-Ausgang (III) 84 log. 0-Pegel annimmt und den Zählerstand löscht, womit sich die Schaltung selbstätig in °
Ausgangssituation versetzt und für die nächste Messung vorbereitet ist.

Somit ist eine Schaltzeitmeßeinrichtung geschaffen worden, womit für besondere Anwendungsbedingungen in der Meßtechnik z.B. für Schalttransistoren für Datenverarbeitungsanlagen bezogen auf ihre Durchschaltgeschwindigkeit unter gleichnamigen Transistoren selektiert werden können. Dabei wird jede Schaltzeitmessung selbstätig und ohne äußeres Hinzutun bei allen Meßarten selbstätig eingeleitet und zum Abschluß gebracht, wobei das Ergebnis der Durchschaltzeit mit Abschluß einer Transistorüberprüfung mit dem Aufhellen der optischen Leuchtanzeige 52 "Messung abgeschlossen" direkt von einer Sieben-Segment-Anzeige 88 ablesbar ist resp. keine Anzeige vorliegt, wenn der Transistor defekt ist.

Außerdem befindet sich in der Schaltzeitmeßeinrichtung eine Eingabetaste 89, über der die Meßschaltung für externe Messungen vorbereitet werden kann. Zu diesem Zweck wird die Digit-Taste 89 "t_{X}-extern" einmal betätigt worauf, das RS-Kippglied 90 einen prellfreien Impuls auf den Takteingang des Delay-Flipflop 91 gibt, dessen Q-Ausgang einerseits das Und-Gatter (III) 92 öffnet und anderseits über Oder-Gatter (III) 84 an den Reset-Eingang des Zählers ein log. 1-Pegel führt, womit der Zähler für einlaufende Impulse an seinem Takteingang 86 freigeschaltet ist. Die Bereitschaft zur Messung eines externen Signals über der Meßeingangsbuchse 93 wird durch die optische Leuchtanzeige 96 mitgeteilt. Dabei wird das zu messende Signal über die Eingangsbuchse 93 auf die Meßschaltung gegeben, wobei die Messung mit einem O-auf-1-Signal eingeleitet wird bzw. mit einer positiven Taktflanke und mit dem Abfall des zu messenden Signals von log. 1-auf-log. 0 abgeschlossen wird. °
Darüber hinaus wird mit der abfallenden Flanke über einen Inverter 94 eine Taktflanke über das Und-Gatter (III) 92 gebildet, welches das Delay-Flipflop 95 taktet und die an seinem Dateneingang anliegende log. 0-Information zum Q-Ausgang schaltet, womit das Und-Gatter (I) 79 verriegelt wird, sodaß keine Taktflanke am Meßeingang 93 Einfluß auf die Meßschaltung nehmen kann. Die gemessene Zeit kann direkt von der Sieben-Segment-Anzeige abgelesen werden und verlischt erst mit Betätigung der Reset-Taste 14 womit die Schaltung im Urzustand versetzt wird, was an der inaktiven Leuchtanzeige 96 "t_{X}-extern" erkennbar ist.

Somit lassen sich neben externe Transistor-Schaltzeiten ferner präzise Zeiten von Mono-flop-Ausgangssignale als auch hochgenaue Ermittlungen von Tastverhältnisse sowie Zeitmessungen von nur einmal auftretenden Impulse meßtechnisch präzise erfassen.

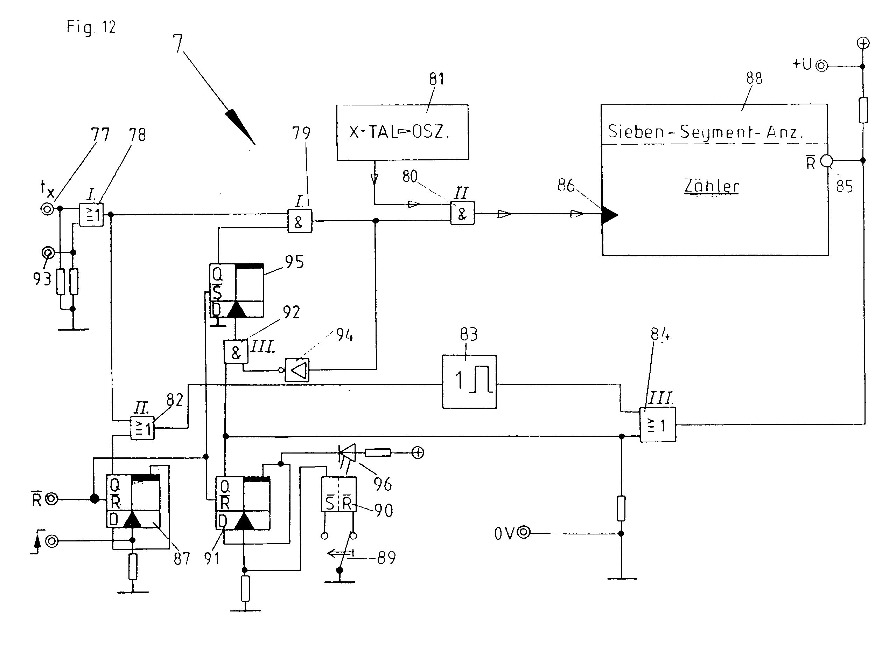

Die speziell entwickelte Schaltung zur Messung der Transistor-Schaltzeiten (Fig.12) kann a.) als separates Meßgerät mit den oben beschriebenen Merkmalen- und b.) darüber hinaus ohne der Zählerschaltung mit der dazugehörenden Sieben-Segment-Anzeige 88 (Fig. 12) als gesonderte "Meßschaltung" zur Meßbereichs-Erweiterung für Frequenzzähler usw. usw. aufgebaut und vertrieben werden.

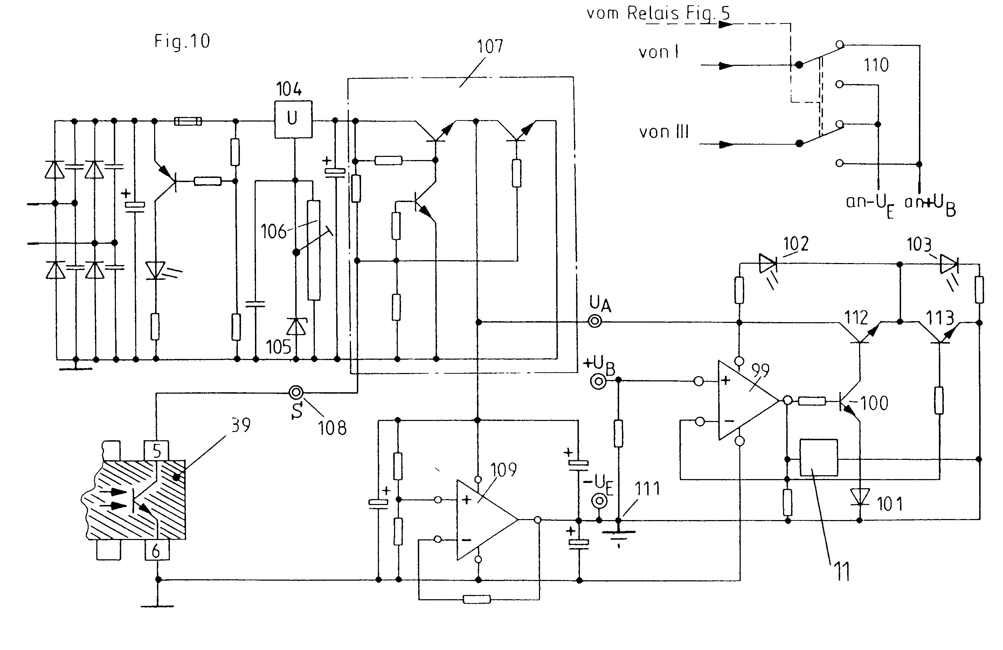

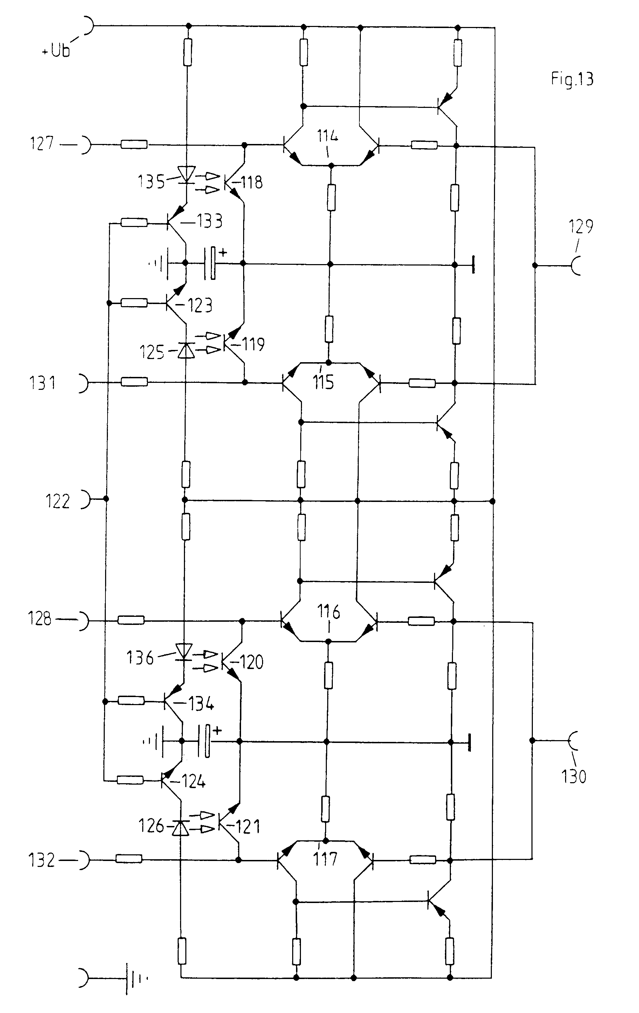

Eine weitere vorteilhafte Ausgestaltung der Erfindung kennzeichnet sich dadurch aus, daß das elektromechanische Relais Fig. 5/Fig. 10 (110) durch einen lichtgesteuerten AC/DC-Umschalter Figur 13 ersetzt werden kann, wodurch sich einerseits eine direkte und schnelle Spannungsanzeige verwirklichen läßt, da die Durchschaltungen der zu messende Analogspannungen verzögerungsfrei erfolgen als auch anderseits sich neben weiteren Vorteilen eine wesentlich günstigere Verdrahtung ergibt. °
Zur Lösung dieser Aufgabe sind vier als Spannungsfolger aufgebaute Differerzverstärker (114, 115, 116, 117) vorgesehen, wobei jeder nichtinvertierende Verstärkereingang über die Kollektor-Emitter-Strecke eines Fototransistors (118, 119, 120, 121) zum Be-zugspotential geschaltet ist. Liegt am gemeinsamen Steuereingang "S" (122) ein log. 1-Pegel an, werden die Transistoren (123, 124) durchgeschaltet und die in deren Kollektorkreisen befindlichen Fotodioden (125, 126) bewirken mit ihrem Lichtstrom die Durchschaltung der Fototransistoren (119, 121) zum Bezugspotential, womit nur die an den Eingängen E1 und E(1) (127, 128) anliegenden Signale zu den Ausgängen A1 und A(1) (129, 130) geschaltet werden. Analog dazu werden die an den Eingängen E2 und E(2) (131, 132) anliegenden Analogsignale dann und nur dann zu den Ausgängen A1 und A(1) (129, 130) durchgeschaltet, wenn sich am Steuereingang "S" (122) ein log. 0-Pegel einstellt. Dann werden über den Transistoren (133, 134) die Fotodioden (135, 136) aktiviert, die ihrerseits die Foto-transistoren (118, 120) durchschalten lassen, womit die Signale an den Eingängen E1 und E(1) (127, 128) nicht zu den Ausgängen A1 und A(1) (129, 130) gelangen können. Somit ist eine Schaltungseinheit geschaffen worden, welche die elektromechanische Relaisschaltung Fig. 10 (110) durch eine vollelektronische (= kontakt-lose) und lichtgesteuerte AC/DC-Umschalter ersetzt wurde. Der Einsatz des lichtgesteuerten Umschalters für den Analog- und Digitalbereich wird durch die externe Verdrahtung bestimmt. Wie hier zeigen sich gegenüber den bekannten Relaisschaltungen die entscheidenden Vorteile dadurch, daß die Ausgangsspannungen absolut korrekt den Eingangsspannungen folgen, da keine Übergangswiderstände gegeben sind, was wie hier bei Messungen von Analogsignalen im Millivoltbereich im besonderem Maße zum Tragen kommt.

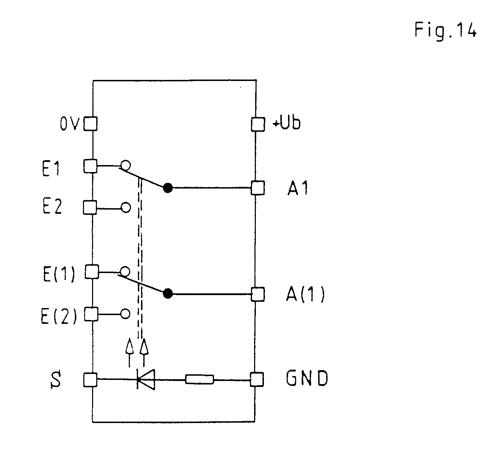

Mit Fig. 14 wird das Schaltzeichen/Blocksymbol des lichtgesteuerten und kontaktlosen Digital-Analog-Umschalters wiedergegeben.

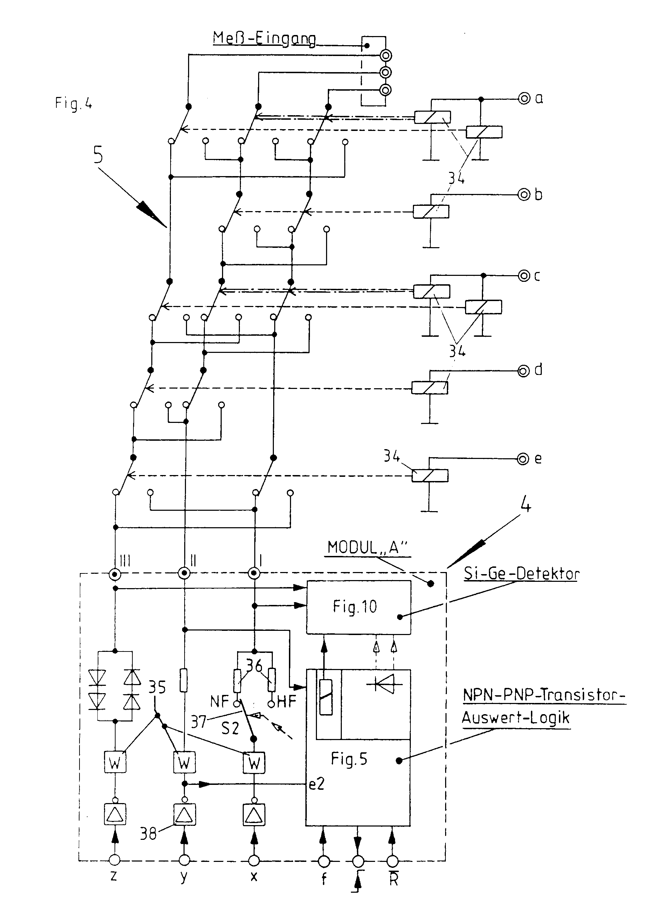

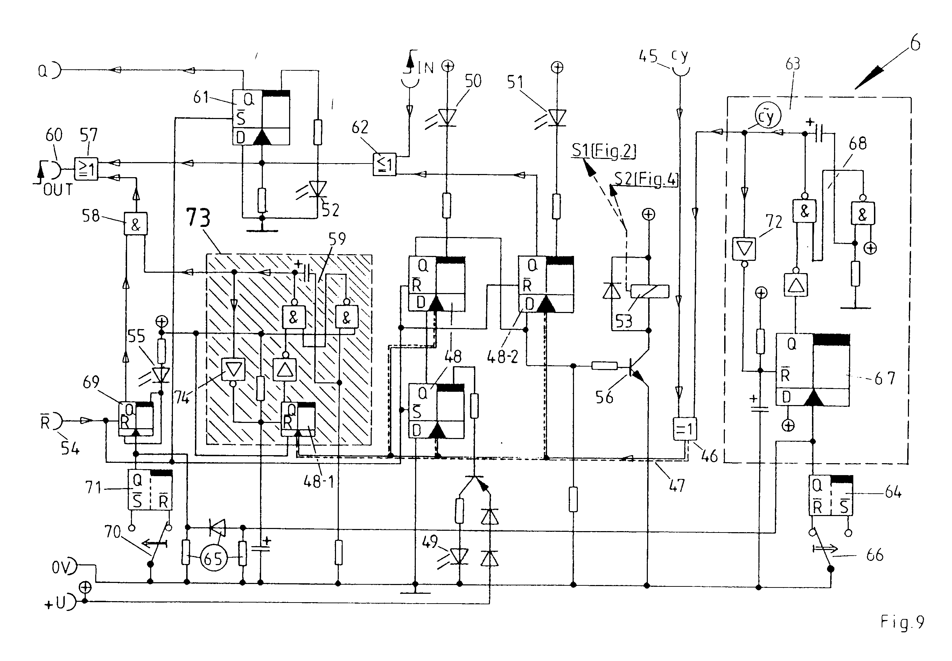

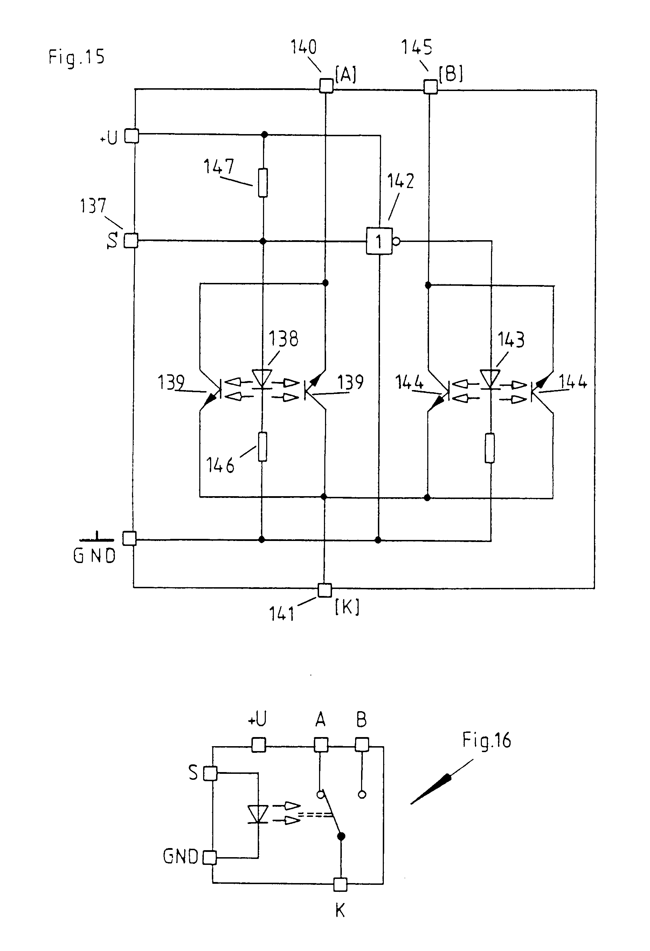

Eine weitere bevorzugte Ausführung der Erfindung ist mit dem Einsatz eines vollelektronischen und kontaktlosen Relais (G 93 18 765.3) gegeben, womit sich zwei weitere vorteilhafte Ausgestaltungen verwirklichen lassen: a.) das elektromechanische Relais Fig. 9 (53) zur Betätigung der Schalter S1 (Fig.2) beziehungsweise S2 (Fig. 4) als auch b.) die elektromechanischen Relais der Relaiskarte Fig. 4 (34), lassen sich durch vollelektronische und kontaktlose Relais ersetzen. Bedingt durch die feste digitale "Verzahnung" der Suchlaufeinrichtung mit den Meß-schaltungen erlaubt die bevorzugte Schaltung eine problemlose Erhöhung der Oszillator-frequenz auf z.B. 500-Hz (!), womit die Überprüfungszeit eines NF-Transistors auf maximal 2ml-Sekunden beschränkt wird. Bedingt durch die Programmierbarkeit des Transistormeßgerätes lassen sich die NF-Transistor-Überprüfungen auf maximal acht Prüf-schritte reduzieren, womit sich rein theoretisch in einer Sekunde über 60 NT-Transistoren auf einer Leiterplatte überprüfen lassen und gleichzeitig über 450 dazugehörige physikalische Daten gewonnen werden können. Der absolute Vorteil beim Einsatz des vollelektronischen und kontaktlosen Relais in der bevorzugten Schaltung ist durch die Entfernung von elektromechanischen Bauelementen in der Schaltung gegeben, wodurch sich alle Schaltungen über die Großintegration in einem einzigen IC zusammenfassen lassen (= zu einem LSI-Baustein) wodurch sich für die Praxis ein Meßgerät in "Westentaschenformat" bauen läßt. Mit Fig. 15 wird die Schaltung des vollelektronischen und kontaktlosen Relais- und mit Fig. 16 das dazugehörige Schaltzeichen/Schaltsymbol wiedergegeben.

### Arbeitsweise des vollelektronischen- und kontaktlosen Relais

Eine am Steuereingang (137) anliegende positive Spannung bewirkt das Aufhellen der Lumineszenzdiode (138), welche als Koppelelement das optische Signal auf den Flächen der lichtempfindlichen Fototransistoren (139) strahlt, worauf die Isolationsschichten vom extrem hochohmigen in den niederohmigen Zustand wechseln, womit die Strecke Klemme A (140)/Klemme K (141) und umgekehrt über den Fototransistor (139) für den anliegenden Strom keinen Widerstand mehr darstellt.°

Der angeordnete Inverter (142) schaltet die Lumineszenzdiode (143) dunkel, worauf die Isolationsschichten der Fototransistoren (144) Hochohmigkeit zeigen und keinen Stromfluß von Klemme B (145) nach Klemme K (141) und umgekehrt erlauben. Liegt jedoch an S (137) Bezugspotential, zeigt sich die Strecke Klemme A (140)/Klemme K (141) und umgekehrt von der hochohmigen Seite. Die Strecke Klemme B (145)/Klemme K (141) zeigt sich jedoch in beiden Richtungen niederohmig, da die Lumineszenzdiode (143) über den Inverter (142) aktiviert wird, worauf die Isolations-schichten der Fototransistoren (144) im niederohmigen Bereich kehren. Die Widerstände (146) bestimmen mit ihrem Wert den Lichtstrom der Diode (138, 143) und damit den Isolationswiderstand der Fototransistoren (139, 144). Liegt kein Signal am Steuereingang S (137) an, hält der Widerstand (147) die Strecke Klemme A (140)/Klemme K (141) niederohmig bzw. hält dieser bei hochohmiger Wahl den Ausgang des Inverters (142) auf log.1-Pegel.

Eine weitere vorteilhafte Ausgestaltung der Erfindung kennzeichnet sich dadurch aus, daß eine Schaltungseinheit vorgesehen ist, welche nach einer einmaligen Betätigung der Taste (148) selbstätig und ohne weiteres Hinzutun eine Überprüfung der korrekten Kontaktgebung des Transistors mit der zur Meßelektronik führenden Meßeingangs-buchse (157) durchführt und das Ergebnis einerseits digital über den Anzeigen (149, 150) zur Anzeige bringt, als auch anderseits eine Meldung zur korrekten Kontaktgebung über den Akustikwandler (151) durchführt. Ferner erlaubt die Schaltung bereits im Vorfeld die Aussage darüber zu erbringen, ob ein Transistor defekt ist oder nicht. Zu diesem Zweck wird nach Anschluß/"Kontaktgebung" des Prüflings mit der Meßeingangsbuchse (157) die Taste (148) einmal betätigt, wo-rauf das Delay-Flipflop (153) vom RS-Flipflop (152) getaktet wird und einerseits die Leuchtanzeige "Keine Kontaktgebung" (150) aufhellen läßt als auch anderseits: °
1.) den Oszillator (154) aktiviert,
2.) die Bedingung für das UND-Gatter (155) erfüllt, sodaß die getastete Gleichspannung zur Eingangsbuchs (159) des NC-Dekoders* (158) gelangen kann, als auch
3.) das Relais (156) anziehen läßt, womit der Prüfling Transistor über der Meßeingangsbuchse (157) mit den Eingängen (166, 167, 168) des NC-Dekoders (158) verbunden ist. Bei korrekter Kontaktgebung des Transistors mit der Meßeingangs- buchse (157) erscheint am Meßpunkt (160) ein log.1-Pegel, welcher einerseits das nicht retriggerbare Monoflop (161) für die Dauer einer beliebig einstellbaren Zeit (hier: 1-Sekunde) aktiviert, als auch anderseits über das EXOR-Gatter (163) das Delay-Flipflop (153) rücksetzt, wodurch:
   1.) die Anzeige "Keine Kontaktgebung" (150) inaktiviert wird,
   2.) die optische Anzeige "Korrekte Kontaktgebung gegeben" (149) aufhellt,
   3.) der Oszillator (154) gestoppt wird,
   4.) die Bedingungen für das UND-Gatter (155) aufgehoben werden,
   5.) das Relais (156) abfällt, und der Prüfling mit der Relaiskarte (5) verbindet,
   womit sich die gesamte Schaltung nach einer vorprogrammierbaren Zeit (hier: 1/2-Sekunde) in Ausgangssituation befindet.

Liegt keine korrekte Kontaktgebung des Prüflings mit der Meßeingangsbuchse (157) vor, erscheint am Ausgang (160) des NC-Dekoders* (158) ein log.0-Pegel, worauf die Schaltung nicht in Ausgangssituation rückgesetzt wird, was an der dann ständig blinkenden optischen Leuchtanzeige "Keine Kontaktgebung" (150) ersichtlich ist . Nach Betätigung der "NC*-Return"-Taste (164) wird die Schaltung in Ausgangs-situation rückgesetzt. Führt nach Überprüfung der korrekten Kontaktgebung die 2.Über-prüfung zum gleichen Resultat, ist der Prüfling Transistor defekt, was im anschließendem Prüfverfahren definitiv mitgeteilt werden kann.

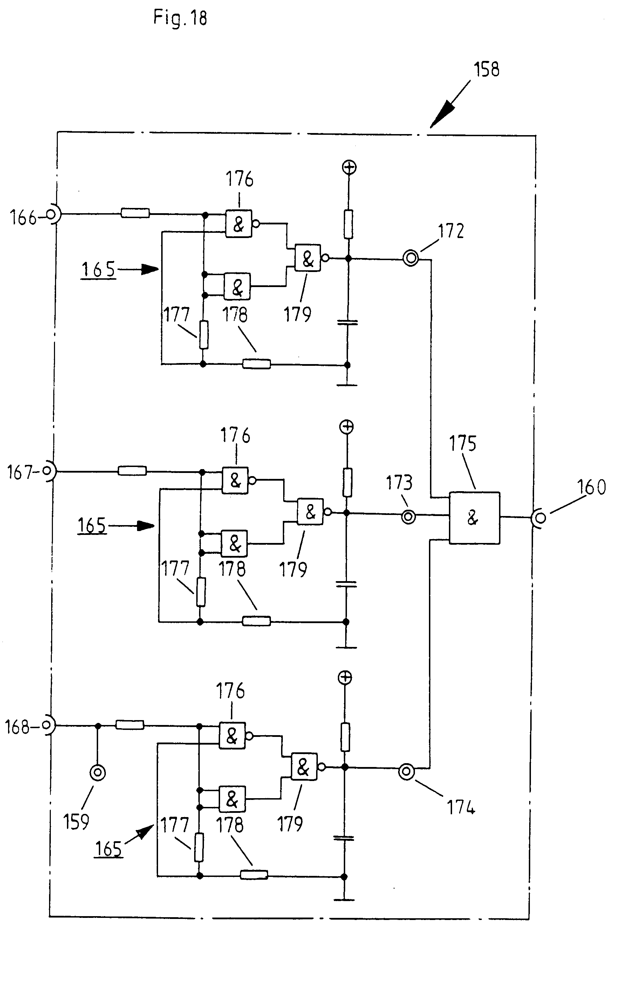

*NC-Dekoder, *NC, NC für: no connection -- keine Verbindung(!) Der NC-Dekoder Fig.18 (158) setzt sich aus drei gleichartig aufgebauten Logikschaltungen (165) zusammen, deren Eingänge (166, 167, 168) über den relais -gesteuerten Schaltern (169, 170, 171) in direkter Verbindung mit der Meßeingangsbuchse (157) stehen und deren Ausgänge (172, 173, 174) mit dem UND-Gatter (175) verbunden sind. Liegt eine korrekte Kontaktgebung des Transistors mit der Meßeingangsbuchse (157) vor und ist der Prüfling nicht defekt, liegt an allen drei Eingängen (166, 167, 168) das über das UND-Gatter (155) gelangende Rechteck-signal an, welches vom NAND-Gatter (176) durch die Widerstände (177, 178) in der Art umgeformt wird, sodaß sich am NAND-Gatter-Ausgang (179) ein log.1-Pegel ein-stellt. Diese Log.1-Informationen gelangen über den Ausgängen (172, 173, 174) zum UND-Gatter (175), welcher am Ausgang des NC-Dekoders (158), der Ausgangsbuchse (160) ein 0-auf-1-Signal erscheinen läßt.

Werden hingegen ein oder mehrere Transistoranschlüsse nicht korrekt mit der Meßeingangsbuchse (157) verbunden, so gelangt an den entsprechenden Eingängen (166, 167, 168) keine getastete Gleichspannung, worauf die zugehörigen Logik-schaltungen (165) die entsprechenden hochohmigen Eingänge (166, 167 oder 168) in der Weise auswertet, sodaß sich an der Ausgangsbuchse (172, 173 oder 174) ein log.0-Pegel einstellt, aus dessem Grund sich am UND-Gatter-Ausgang (160) kein 0-auf-1-Signal einstellen kann.

Eine weitere bevorzugte Ausführung der Erfindung ist mit dem SMD-Bauteilprüfstift gegeben, welcher die direkte Überprüfung von aktiven SMD-Halbleiterbausteinen auf den Leiterplatten über nur einem dreiadrigen Meßkabel erlaubt.

Zu diesem Zweck wird das Meßkabel (180) einerseits mit der Meßeingangsbuchse (157) als auch anderseits über eine Klinkenkupplung (181) mit dem Klinkenstecker (182) des Tastkopfträgers (183) verbunden. Über das Gewinde (184, 185) erfolgt eine feste Verschraubung des Tastkopfes (186) mit dem Tastkopfträger (183), wobei °
der Tastkopf (186) selber Träger der drei Prüfspitzen (187) ist. Die sichere elektrische Verbindung des dreiadrigen Meßkabels (180) mit den Prüfspitzen (187) erfolgt durch Verlötung der Litzenenden mit dem Kelch (188) der Prüfspitzen (187). Nach dem Herausziehen der Klinkenkupplung (181) aus dem Klinkenstecker (182) und dem Aufstecken einer abgerundeten Meßspitzenschutzkappe, läßt sich der SMD-Bauteilprüfstift problemlos in der Brusttasche des Hemdes mitführen, da ein Haltebügel (189) vorgesehen ist.

Das Transistormeßgerät verfügt bezüglich der Programmierbarkeit über einige nachstehende Besonderheiten:
1. Mit der Inbetriebnahme des Transistormeßgerätes oder nach Betätigung der Reset-Taste 14 (Fig. 2) befindet sich das Gerät in einem vorprogrammierten Zustand. In dieser Ausgangssituation ist eine "Vollmessung" vorgesehen, wobei im 1. Intervall eine NF- und im 2. Intervall eine HF-Transistorüberprüfung durch-geführt wird. Dieser Betriebszustand wird durch die Leuchtanzeige 55 (Fig. 9) "Vollmessung" angezeigt. Dabei findet der Wechsel von der NF- zur HF-Transistorüberprüfung selbstätig und ohne äußeres Hinzutun statt, was rein optisch über der Leuchtanzeige 49 (Fig. 9) "NF-Transistor-Überprüfung" und 50 (Fig. 9) "HF-Transistor-Überprüfung" verfolgt werden kann. Hat der letzte Prüfschritt im 2. Inter-vall zu keinem Resultat geführt, ist der Transistor defekt, was durch die Leuchtanzeige 51 (Fig. 9) "Transistor defekt" angezeigt wird. Das die Überprüfungen abgeschlossen sind, ist ferner an der dann aktiven Leuchtanzeige 52 (Fig. 9) "Mes-sung abgeschlossen" ersichtlich.
2. Soll nur eine NF-Transistor-Überprüfung durchgeführt werden, ist vor Betätigung der Start-Taste 27 (Fig. 2) die Digit-Taste 70 (Fig. 9) "NF-Transistor-Überprüfung" einmal zu betätigen. Dann verlischt die Anzeige 55 (Fig. 9) "Vollmes-sung" und die Anzeige 49 (Fig. 9) "NF-Transistor-Überprüfung" signalisiert die be-vorstehende NF-Transistor-Überprüfung. Ist der NF-Transistor defekt, wird das Ende des letzten Prüfschrittes mit der dann ständig aufleuchtenden Oszillatoranzeige 19 (Fig. 2) angezeigt und dies darüber hinaus mit dem Hinweis, mit Betätigung der Start-Taste 27 (Fig. 2) eine HF-Transistor-Überprüfung einzuleiten.
3. Soll nur eine HF-Transistor-Überprüfung durchgeführt werden, ist vor Betätigung der Start-Taste 27 (Fig. 2) die Digit-Taste 66 (Fig. 9) "HF-Transistor-Überprüfung" einmal zu betätigen. Dann verdunkeln sich die Anzeige 55 (Fig. 9) "Voll-messung" sowie 49 (Fig. 9) "NF-Transistor-Überprüfung" und die allein aufleuchtende Anzeige 50 (Fig. 9) "HF-Transistor-Überprüfung" signalisiert die Einzelmessung "HF-Transistor-Überprüfung". Der Abschluß des letzten Prüfschrittes wird mit der Leuchtanzeige 52 (Fig. 9) "Messung abgeschlossen angezeigt. Ist der Prüfling defekt, wird dies durch die Anzeige 51 (Fig. 9) "Transistor defekt" mitgeteilt. °
   Ferner verfügt das Transistormeßgerät über nachstehende Besonderheit:
4. Das Transistormeßgerät beinhaltet eine speziell entwickelte Schaltung zur Erfassung bzw. zur Messung der Transistor-Schaltzeiten, die selbstätig und ohne äußeres Hinzutun eingeleitet, durchgeführt und zum Abschluß gebracht werden. Die Ausrichtung der Meßschaltung erfolgt dabei selbstätig mit Inbetriebnahme des Transistormeßgerätes bzw. mit der Betätigung der Reset-Taste 14 ( Fig. 2 ). Ferner wird mit jedem Taktsignal, mit dem eine Transistorprüfung eingeleitet wird, eine Schaltzeitmessung begonnen. Ist der Prüfling in Ordnung, wird die Schaltzeitmessung mit dem Signal abgeschlossen, mit dem auch der Oszillator 12 (Fig. 2) gestoppt wird und die effektive Transistor-Durchschaltzeit wird direkt über der Sieben-Segment-Anzeige 88 (Fig. 12) angezeigt. Ist der Transistor defekt, liegt keine Anzeige vor. °

Das Transistormeßgerät arbeitet wie folgt :
Die Start/Stop-Einrichtung 2 (Fig. 2) weist eine RC-Kombination 16 auf, die mit der Inbetriebnahme des Transistormeßgerätes alle an ihr angeschlossenen Delay-Flipflops in einer geordneten Ausgangssituation versetzt, so daß die Reset-Taste 14 nicht mit der ersten, sondern nur vor den danachfolgenden Transistorüberprüfungen einmal betätigt werden muß, um die Speicherbausteine in einer korrekten Meßausgangssituation zu versetzen. Ferner gehört zur Start-Stop-Einrichtung 2 eine Start-Taste 27, womit das Delay-Flipflop 15 gesetzt wird und mit dem an seinem Q-Ausgang erscheinenden log. 1-Signal der Start/Stop-Oszillator 12 gestartet wird. Dabei wird über den Schalt/Entlade-Transistor 17 sichergestellt, daß der Oszillator 12 seine Schwingungen stets mit einer ansteigenden positiven Taktflanke beginnt, womit weiter sichergestellt ist, daß die erste Meßzeit gleich groß ist wie die darauffolgenden Meßzeiten. Dem Oszillator 12 ist ein Delay-Flipflop 13 nachgeschaltet, womit das Signal am Q-Ausgang vom Delay-Flipflop 13 ein Tastverhältnis von 1 : 1 aufweist. Daß der Oszillator 12 seine Schwingungen mit einer positiven Taktflanke einleitet und daß das Tastverhältnis 1 : 1 ist und ferner die 1. Meßzeit gleich groß ist wie die darauffolgende Meßzeiten, wird von der Oszillator-Leuchtanzeige 19 angezeigt. Das symmetrische Ausgangssignal gelangt unverfälscht über ein von vier vorhandenen Eingängen eines Oder-Gatters 21 über einen von zwei vorhandenen Eingängen eines Und-Gatters 22 einerseits zur Ausgangsbuchse 24, von wo aus es weiter zum Schaltzeitmeßgerät 7 weitergeleitet wird und anderseits über eine Ausgangsklemme auf den Takteingang eines Vier-Bit-Binärzählers 29 (Fig. 3).

Der an den Ausgängen Q1, Q2 und Q3 des Binärzählers 29 erscheinende 3-Bit-Binär-Code wird in einem Binär/Dezimal-Wandler, der aus den Und-Gattern 30 und den Invertern 31 mit nachgeschalteten Treiberstufen 32 aufgebaut ist, in einen Dezimal-Code umgewandelt, von denen die Signale 1, 2, 3, 4, 5 und 6 an der Anzeige 8 (Fig. 1) für die Belegung der Transistoranschlüsse anliegen und außerdem über den parallel zu den Ausgängen 1 bis 5 belegten Ausgangsklemmen a, b, c, d und e zur Relaiskarte 5 (Fig. 4) geführt sind. Der Q4-Ausgang des Binärzählers 29 wird einerseits über eine Treiberstufe 32 zum Ausgang N/P zu einer NPN/PNP-Anzeige 9 (Fig. 6) geführt, während das an der Ausgangsklemme anliegende Q4-Signal anderseits über die Klemme "f" der Umsetzbaugruppe 3 (Fig.3) zur indirekten Ansteuerung des Relais in der Auswertlogik (Fig. 5) herangezogen wird. Ferner werden die Q1-, Q2- und Q3-Signale des Binärzählers 29 zu einer aus Exor-Gatter 33 bestehenden Schaltung geführt, wobei die an den Ausgangsklemmen X, Y und Z erscheinenden Signale einerseits durch die von den Und-Gatter-Ausgängen 30 auf die Exor-Gatter-Eingängen 33 geführten Signale, sowie auch anderseits durch die vom Q4-Ausgang des Binärzählers 29 auf die Exor-Gatter-Eingängen 33 geführten Signale in der Weise geprägt werden, so daß bei einer NPN-Transistorüberprüfung sich an Klemme X stets ein log. 0-Pegel- und an den Klemmen Y und Z ein log. 1-Pegel einstellen, während analog zu einer PNP-Transistorübeiprüfung sich die um 180⁰-Grad entgegengesetzten Logik-Pegel einstellen. Die Signale X, Y und Z der Umsetzbaugruppe werden den X-, Y- und Z-Eingängen des Moduls "A" 4 (Fig. 4) zugeführt.

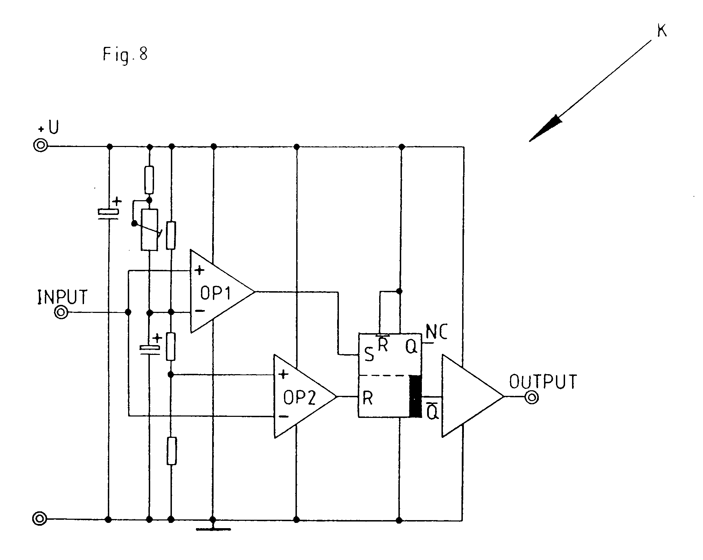

In Fig. 4 erkennt man die schon erwähnten Eingänge a bis e, denen jeweils Relais 34 zugeordnet sind, mit welchen die Transistoranschlüsse des in den Meß-Eingang (Fig. 1) gesetzten Transistors in den möglichen Kombinationen beschaltet werden. Die drei erforderlichen Spannungen für die Transistor-Prüfschaltung werden im Modul "A" 4 über die an den Eingängen X, Y und Z geschalteten vollelektronischen Relais 35 (Fig. 7)/"W" gewonnen. Dabei werden die für die NPN/PNP-Transistor-Auswertlogik (Fig. 5) interessierenden Spannungen dem Kollektorkreis der Transistor-Prüfschaltung entnommen, der durch die Baugruppen zwischen der Eingangsklemme Y und der Ausgangsklemme II gebildet wird. Zu dieser Auswertlogik (Fig. 5) gehört ein Komparator 40 (Fig. 5) mit einer in Fig. 8 wiedergegebenen Präzisionsschaltung. Der Komparator 40 spricht an, wenn am Kollektor des untersuchten Transistors ein bestimmter Spannungsabfall auftritt, dessen Bildung einzig und allein auf die Diodenschaltung
bestehend aus den vier Siliziumdioden
zwischen der Eingangsklemme Z und der Ausgangsklemme III auf dem Modul "A" 4 (Fig. 4) zurückzuführen ist.

Dann schaltet der Komparator 40 den Oszillator 12 (Fig. 2) ab, womit die Messung abgeschlossen ist, was durch die Leuchtanzeige 52 (Fig. 9) "Messung abgeschlossen" mitgeteilt wird.

Über die optische Leuchtanzeige 8 (Fig. 1) wird die Anschlußbelegung des Transistors in Verbindung mit den drei Zahlen 1, 2, und 3 an der Meßeingangsbuchse bzw. an den Prüfspitzen der Prüfklemmen ersichtlich. Ist der Transistor defekt, zeigen sich die Leuchtanzeigen von der inaktiven Seite.

Die NPN/PNP-Anzeige 9 zeigt über zwei Leuchtdioden 97, 98 (Fig. 6) die Dotierungsfolge des Prüflings an. Ist der Transistor defekt, zeigt die NPN/PNP-Anzeige 9 die Rücksetzung der gesamten Logik mit der NPN-Anzeige 97 an, während die verbleibende Information wie "Messung abgeschlossen" oder "Transistor defekt" bis zur Einleitung einer neuen Messung durch Betätigung der Reset-Taste 14 (Fig. 2) gespeichert bleiben.

Mit dem dargestellten Transistormeßgerät wird gleichzeitig auch festgestellt, ob es sich um einen Germanium-Transistor oder einen Silizium-Transistor handelt. Der zugeordnete Silizium-Germanium-Detektor ist in Fig. 10 wiedergegeben. Zum Detektor gehört der Optokoppler 39, der über den Steuereingang "S" 108 die über den Bauteilen Spannungsregler-IC 104, Zener-Diode 105 und dem einstellbaren Widerstand/Potentiometer 106 erzeugte stabilisierte Spannung zur Ausgangsklemme U_{A} des elektronischen Relais 107 schaltet, wodurch der aktive duale Spannungsteiler 109 die für den Betrieb des Impedanzwandler 99 erforderliche duale Spannungsversorgung bereitstellen kann. Somit kann die interessierende Basis/Emitter-Spannung von der relativ hochohmigen Transistor-Prüfschaltung von den Klemmen I und III (Fig. 4) über eine Relaisschaltung 110 den Eingängen des Impedanzwandlers +U_{B} und -U_{E} 99 zugeführt werden, womit einerseits der Prüfling nicht belastet wird und anderseits die +U_{BE}-Spannung niederohmig am Ausgang der Impedanzwandlerschaltung 99 zur Verfügung steht. Der niederohmige Ausgang der Impedanzwandlerschaltung 99 liegt einerseits niederohmig über einen Germanium-Transistor 100 und an einer an dessen Emitter angeschlossenen Siliziumdiode 101 an der Bezugsspannung an, wodurch über den Transistoren 112 und 113 eine Ansteuerung der Anzeige 102, 103 für "Silizium" bzw. "Germanium" möglich wird. Wenn der Komparator 40 (Fig. 5) den Oszillator 12 (Fig. 2) abschaltet, schaltet er gleichzeitig den Optokoppler 39 ein. Wenn am Ausgang des Impedanzwandlers 99 eine Spannung von etwa 600-mV liegt, das ist die Basis-Emitter-Spannung eines Silizium-Transistors, wird durchgeschaltet und die Anzeige 102 für "Silizium" leuchtet auf. Wenn am Ausgang des Impedanzwandlers 99 eine Spannung von ca. 300-mV liegt, das ist die Basis-Emitter-Spannung eines Germanium-Transistors, wird nicht durchgeschaltet, und die Anzeige 103 für "Germanium" leuchtet auf. Wenn der zu prüfende Transistor defekt ist, leuchtet keine Anzeige 102, 103 auf.

Die für Meßschaltungen wichtig zu erfassenden, aber stark streuenden Basis-Emitter-Spannungen werden mit dem im Ausgangskreis der Impedanzwandlerschaltung 99 geschalteten digitalen Millivoltmeter 11 präzise ablesbar, womit eine korrekte Selektierung möglich ist. Ist der Transistor defekt, liegt keine Anzeige vor.

Mit dem dargestellten Transistormeßgerät wird gleichzeitig die für jeden Transistor typische Durchschaltzeit meßtechnisch erfaßt und zur Anzeige gebracht. Die Schaltung des zugeordneten Schaltzeit-Meßgerätes ist in Fig. 12 wiedergegeben. Dabei wird jede Schaltzeitmessung mit der positiv ansteigenden Taktflanke eingeleitet, die von der Ausgangsbuchse 24 (Fig. 2) der Start/Stop-Einrichtung 2 auf den Meßeingang 77 geführt wird. Das Meß-Einleitsignal gelangt zum Und-Gatter 80, welches öffnet und die vom Oszillator 81 kommenden Impulse in den Zähler einlaufen läßt. Das zeitgleich getriggerte Monoflop 83 hält mit seinem log. 1-Signal den Zähler frei. Gelangt kein Stop-Signal von der Buchse 60 (Fig. 9) der NF/HF-Umschalt-und Anzeigelogik 6 auf den Takteingang vom Delay-Flipflop 87, wird mit der Pegeländerung des Meß-Einleit-Signals auf log. 0-Pegel der Zählerinhalt über den nicht mehr getriggerten retriggerbaren Monoflop 83 am Reset-Eingang 85 mit einem Low-Pegel gelöscht. Gelangt jedoch vor Pegeländerung des Meß-Einleit-Signals von log. 1 auf log.0 das Stop-Signal auf den Takteingang des Delay-Flipflops 87, bleibt das Monoflop 83 trotz der darauffolgenden Pegeländerung am Meßeingang 77 von log. 1 auf log. 0 weiterhin getriggert, wofür der Q-Ausgang vom Delay-Flipflop 87 nun zuständig ist. Da mit der zweiten Pegeländerung an der Meßeingangsbuchse 77 einerseits der Zählerinhalt nicht gelöscht wird und anderseits keine weiteren Impulse über das Und-Gatter 80 in den Zähler einlaufen können, wird mit Abschluß einer Transistorüberprüfung die Transistor-Durchschaltzeit direkt von der Sieben-Segment-Anzeige 88 wiedergegeben. Ist der zu prüfende Transistor defekt, liegt keine Anzeige vor.

Zur Messung externer Schaltzeiten, präzisen Zeiten von Monoflop-Ausgangssignalen, zur Ermittlung hochgenauer Tastverhältnissen zweier "vorliegenden" Signalen sowie zur meßtechnischen Zeiterfassung extrem kurzlebiger Impulse usw. usw., wird nach Betätigung der Reset-Taste 14 (Fig. 2) die Taste 89 "t_{X}-extern" einmal betätigt, wobei die Leuchtanzeige 96 die Bereitschaft einer Messung anzeigt. Das zu messende Signal wird über den Meßeingang 93 eingegeben. Bezogen auf den Meßablauf gelten die oben beschriebenen Schilderungen. Lediglich das Delay-Flipflop 95 ist über das Und-Gatter 92 und der Inverterstufe 94 mit eingeschliffen, wodurch mit der zweiten Pegeländerung am Meßeingang 93 das Delay-Flipflop 95 die Meßschaltung über das Und-Gatter 79 verriegelt, so daß ein zweites Meßsignal an der Eingangsbuchse 93 das Meßergebnis nicht mehr verfälschen kann. Eine neue externe Schaltzeitmessung ist erst nach Betätigung der Reset-Taste 14 (Fig. 2) und der Taste 89 "t_{X}-extern" möglich.

## Patentansprüche

1. Transistormeßgerät mit einer Suchlaufeinrichtung zur Ermittlung der Transistoranschlüsse und des Transistortyps PNP bzw. NPN und mit zugeordneten Anzeigen, dadurch gekennzeichnet, daß die Suchlaufeinrichtung einen Oszillator (12) mit einem nachgeschalteten Binärzähler (29) aufweist, wobei die Ausgänge des Binärzählers (29):
I.) über Binär/Dezimalwandler (30, 31) die Anzeigen (8) ansteuern,
II.) die Relais (34) zum Umschalten der Transistoranschlüsse betätigen,
III.) über die Klemme "f" (3) indirekt die Relaisschaltung (110) angesteuert wird,
sowie anderseits über Pegelwandler (35) zu den Kontakten der die Transistoranschlüsse versorgenden Relais (34) geführt sind, und daß ein Komparator ( 40 ) vorgesehen ist, der den Oszillator (12) abschaltet, wenn am Kollektor des untersuchten Transistors ein bestimmter Spannungsabfall auftritt dessen Bildung auf die Diodenschaltung zwischen der Eingangsklemme "Z" und der Ausgangsklemme "III" (4) zurückzuführen ist.

2. Transistormeßgerät nach Anspruch 1, welche eine Start/Stop-Einrichtung (2) vorsieht und sich dadurch kennzeichnet, daß
a.) dem Oszillator (12) ein Delay-Flipflop (15) zur Realisierung eines Tastverhältnisses von 1 : 1 nachgeschaltet ist, wodurch der Binärzähler (29) stets mit einem symmetrischem Signal angesteuert wird, und das
b.) eine Reset-Taste (14) vorgesehen ist, über der alle an ihr angeschlossenen Speicherbausteine in einer geordneten Meßausgangssituation versetzt werden und das
c.) eine RC-Kombination (16) vorgesehen ist, über der alle an ihr angeschlossenen Speicherbausteine mit der Inbetriebnahme des Transistormeßgerätes selbstätig und ohne äußeres Hinzutun in einer geordneten Ausgangssituation versetzt werden, sodaß vor der 1.Messung die Reset-Taste (14) nicht betätigt werden muß, und das
d.) ein Entlade-Schalttransistor (17) im Oszillatorkreis (12) vorgesehen ist, wodurch der Kondensator (18) im inaktivem Zustand des Oszillators (12) absolut entladen wird, wodurch I.) jede Messung mit einer positiv ansteigenden Taktflanke am Takteingang des Binärzählers (29) eingeleitet wird, II.) die erste Meßzeit gleichlang ist wie die darauffolgenden Meßzeiten, III.) sich ein Dauerleuchten der Oszillatoranzeige (19) einstellt, wenn der Oszillator (12) vom Übertragssignal "CY" vom Binärzähler (29) kommend gestoppt wird, womit in der Betriebsart "Niederfrequenz-Transistor-überprüfung definitiv mitgeteilt wird, daß der NF-Transistor defekt ist, und das
e.) ein Potentiometer (20) im Oszillatorkreis (12) vorgesehen ist, womit vor einer NF-Transistorüberprüfung die Oszillatorfrequenz f OSZ innerhalb eines gegebenen Bereichs frei einstellbar ist, und das
f.) ein Oder-Gatter (21) mit vier Eingängen vorgesehen ist, über dessen ersten Eingang die symmetrische Taktfrequenz unverfälscht über ein Und-Gatter (22) zum Binärzähler (29) gelangt, und dessen zweiter Eingang in direkter Verbindung mit dem Ausgang des Simulators (10) steht, und dessen dritter Eingang in direkter Verbindung mit einer BNC-Buchse zwecks Anschlußes eines externen kabelgebundenen Simulators steht, und dessen vierter Eingang zum Anschluß einer kabellosen Fernbedienung zwecks Simulation der Taktfrequenz in der Betriebsart "Einzel-schrittmessung" dient, und das
g.) eine Abzweigung vom Und-Gatter (22) zur Ausgangsbuchse "t" (24) gegeben ist, welche in direkter Verbindung mit der Eingangsbuchse (77) eines Schaltzeitmeßgerätes (7) steht, über der die zu messenden Signale für Meßbeginn und Meßende geführt werden, und das
h.) sich im Oszillator (12) der Schalter (28) vom Relais (53) zur Änderung der Oszillatorfrequenz befindet, wodurch von einer Niederfrequenz-Transistor-Prüfung auf eine Hochfrequenz-Transistor-Prüfung geschaltet werden kann, sodaß die erste von zwei erforderlichen Bedingungen zur Selektierung von NF- als auch HF-Transistoren gegeben ist.

3. Transistormeßgerät nach einem der Ansprüche 1 bis 2, daß dem Komparator (40) ein Silizium-Germanium-Detektor (Fig. 10) folgt und dieser dadurch gekennzeichnet ist, daß
a.) der Silizium-Germanium-Detektor einen Optokoppler (39) und einen Impedanzwandler (99) zu seiner Funktion vorsieht, wobei der Impedanzwandler eine duale Spannungsversorgung benötigt und einen niederohmigen Ausgang aufweist und der Ausgang einerseits niederohmig über einen Germanium-Transistor (100) und eine an dessen Emitter angeschlossene Silizium-Diode (101) an der Bezugsspannung sowie anderseits an Anzeigen für "Silizium" (102) bzw. "Germanium" (103) anliegt, womit ohne äußeres Hinzutun festgestellt werden kann, aus welchem Halbleiterausgangsdotierungsmaterial der zu untersuchende Transistor hergestellt ist, und das
b. ein Potentiometer (106) vorgesehen ist, wodurch die Ausgangsspannung eines Festspannungsregler-IC (104) unter Hinzunahme der Zener-Diode (105) durch Anhebung des Bezugspotentials auf gewünschter Höhe gewählt werden kann, und das
c.) eine Relais-Schaltung (110) vorgesehen ist, wodurch die hochohmige +UBE -Spannung bei einem zu überprüfenden NPN-Transistor bzw. die hochohmige -UEB -Spannung bei einem zu überprüfenden PNP-Transistor stets mit der korrekten Polarität dem sehr hochohmigen Eingang des als Impedanzwandler geschalteten Operationsverstärkers (99) zugeführt werden kann, womit die Basis/Emitter-Spannungen stets mit der gewünschten Polung und unverfälscht am Ausgang des Impedanzwandlers (99) zur Verfügung steht, und das
d.) zwischen dem Ausgang der Impedanzwandlerschaltung (99) und dem virtuellenNullpunkt (111) einerseits ein digitales mV-Meter (11) geschaltet ist, womit charakteristische Spannungsschwankungen unter gleichnamige Transistoren bezüglich der Basis/Emitter-Spannung selektiert werden können und anderseits recht niederohmige, analoge Meßwerke mit nur einem Richtungsausschlag zwischengeschaltet werden können, was auf die Relaisschaltung (110) zurückzuführen ist, und das
e.) ein vollelektonisches Relais bestehend aus den Transistoren (100, 112, 113) vorgesehen ist, wodurch einerseits eine kontaktlose Schaltung und anderseits eine verzugsfreie Leuchtanzeige für "Silizium" (102) und "Germanium" (103) gegeben ist, und das
f.) ein Optokoppler (39) zur direkten Ansteuerung des vollelektronischen Relais (107) vorgesehen ist, welcher einerseits eine Signalübertragung zwischen den elektrisch isolierten Stromkreisen mit unterschiedlichen Spannungspegeln ermöglicht und anderseits eine kontaktlose Verbindung zwischen zwei Schaltungen mit unterschiedlichen Spannungspotentialen schafft.

4. Transistormeßgerät nach einem der Ansprüche 1 bis 3, welche eine NF/HF-Umschalt-und Anzeigelogik (6) vorsieht und sich dadurch kennzeichnet, daß
a.) das Übertragssignal "CY" vom Binärzähler (29) kommend zur gesamten Steuerung der NF/HF-Umschalt-und Anzeigelogik (6) herangezogen wird. Dieses wird dadurch erreicht, daß das Übertragssignal "CY" über der Eingangsbuchse (45) und über einem von zwei möglichen Eingängen eines EXOR-Gatters (46) die vier an einer Taktleitung (47) liegenden Delay-Flipflops (48) zeitgleich taktet, wodurch die vor dem Erscheinen des "CY"-Signals an den Dateneingängen der jeweiligen Delay-Flipflops (48) anliegenden Logik-Pegeln zu den Q-Ausgängen durchgeschaltet werden, womit einerseits die Leuchtanzeigen "NF-Transistor-Prüfung" (49), "HF-Transistor-Prüfung" (50), "Transistor-defekt" (51) und "Messung abgeschlossen" (52) entsprechend der Tiefe der durchgeführten Prüf/Meß-Schritte zum Aufleuchten angesteuert werden und anderseits der am Dateneingang "D" des Delay-Flipflops (48-2) angeschlossene Transistors (56) das in seinem Kollektorkreis geschalteten Relais (53) abfallen resp. anziehen läßt, wodurch der Schalter S1 (28) als auch der Schalter S2 (37) entsprechend der Programmtiefe, für eine NF- oder HF-Transistorprüfung geschaltet wird, und das
b.) eine Eingangsbuchse (54) vorgesehen ist, über der die gesamte Logik der NF/HF-Umschalt-und Anzeigelogik (6) mit dem "Master-Clear-Signal/General-Signal" mit Meßbeginn selbstätig ausgerichtet wird und sich in der Betriebsart "Vollmessung" befindet, was mit der optischen Leuchtanzeige "Vollmessung" (55) angezeigt wird, und das
c.) ein Relais (53) vorgesehen ist, welches sich im Kollektorkreis der Transistorstufe (56) befindet, über dem die zwei Schalter (28, 37) umgelegt werden, die einerseits eine Veränderung der Oszillatorfrequenz im Oszillator (12) und anderseits die Zwischenschaltung eines anderen Meßwiderstandes (36) in der Transistorprüfschaltung (4) zur Folge haben, wodurch einerseits von einer NF-Transistorprüfung zu einer HF-Transistorprüfung und umgekehrt gewechselt werden kann, anderseits aber auch erst eine Selektierung von NF-Transistoren und HF-Transistoren selbstätig und ohne äußeres Hinzutun möglich wird, und das
d.) ein Exklusiv-Oder-Gatter (46) vorgesehen ist, welches einerseits die Zuführung des vom Binärzähler (29) kommenden CY-Signals als auch das vom CY-Simulator (63) gebildete Ausgangssignal auf die Taktleitung (47) erlaubt und anderseits eine Wandlerfünktion übernimmt, wodurch mit den zwei unterschiedlich aussehenden Signalen a.): CY-Signal vom Binärzähler (12) und b.): Ausgangssignal vom CY-Simulator (63) die am Ausgang vom Exor-Gatter (46) angeschlossenen Delay-Flipflops (48) getaktet werden können, und das
e.) ein CY-Simulator (63) vorgesehen ist, dessen Ausgang in fester Verbindung mit einem von zwei möglichen Eingängen des Exor-Gatters (46) steht, und die Nachbildung des vom Binärzählers (29) kommenden CY-Signals erlaubt, sodaß mit der am Eingang des CY-Simulators (63) liegenden Digit-Taste (66) mit der Bezeichnung "HF-Transistor-Überprüfung" Einfluß auf den vorprogrammierten Programmablauf genommen werden kann, wobe dies in der Weise erfolgt, daß nach Betätigung der Taste (66) "HF-Transistor-Überprüfung" das RS-Flipflop (64) einen Impuls auf den Takteingang des Flipflop (67) gibt, womit über dessen Q-Ausgang das retriggerbare Monoflop (68) getriggert wird und einerseits das Exor-Gatter (46) mit einem log. 1-Signal ansteuert und anderseits ein am Monoflop-Ausgang (68) angeschlossener Inverter (72) das Signal um 180 0-Grad dreht, womit das Flipflop (67) selbstätig zurückgesetzt wird und sich die Schaltung des CY-Simulators (63) wieder in Ausgangssituation befindet, während das simulierte CY-Signal über den EXOR-Gatter (46) auf die Taktleitung (47) gelangt, von wo aus es Einfluß auf die Schaltung nimmt, und das
f.) ein "Verrieglungs-Delay-Flipflop" (61) vorgesehen ist, welches mit jedem Abschluß einer Transistorüberprüfung selbstätig die Verrieglung der Start/Stop-Einrichtung (2) durchführt, sodaß auch bei der Benutzung des Simulators (10) nach Abschluß einer Transistorüberprüfung, kein Einfluß durch ungewollte Betätigung des Simulators (10) auf den Binärzähler (29) genommen werden kann, wobei dies in der Weise erfolgt, daß ein Oder-Gatter (62) mit zwei Eingängen vorgesehen ist, über dem einerseits das Stop-Signal der Auswertlogik und anderseits das Q-Ausgangssignal des Delay-Flipflop (48-2) geführt werden und eines dieser Signale zum Takteingang des Flipflop (61) gelangt, womit das dann am Ausgang vom Flipflop (61) erscheinende Signal zur Verrieglung der Start/Stop-Einrichtung (2) herangezogen wird und der Zeitpunkt der Verrieglung über die optische Anzeige (52) erfolgt, und das
g.) eine Einrichtung vorgesehen ist, die den Eingriff im Programmablauf erlaubt, sodaß eine alleinige NF-Transistor-Überprüfung durchgeführt werden kann, wobei dies in der Weise erfolgt, daß nach Betätigung der Taste "NF-Transistor-Überprüfung" (70) über ein RS-Kippglied (71) ein Impuls auf den Takteingang des Delay-Flipflop (69) gegeben wird, wonach die Leuchtanzeige (55) "Vollmessung" verlischt und anderseits ein am Ausgang des Flipflop (69) angeschlossener Und-Gatter-Eingang (58) mit einem log. 1-Pegel beaufschlagt wird, sodaß eines nach Ablauf einer NF-Transistor-Überprüfung am Ausgang der Signal-Wandlerschaltung (73) erscheinende log. 1-Pegel über das Und-Gatter (58) und Oder-Gatter (57) zur Start/Stop-Einrichtung (2) gelangt, wodurch der Oszillator gestoppt wird und die NF-Transistor-Überprüfung abgeschlossen ist, und das
h.) eine Einrichtung vorgesehen ist, die den Eingriff im Programmablauf bezüglich einer alleinigen HF-Transistor-Überprüfung erlaubt, zu dessen Funktionieren der CY-Simulator (63), das daran angeschlossene RS-Kippglied (64), eine am Q-Ausgang des RS-Kippgliedes (64) angeschlossene R-D-R-Kombination ( 65 ), sowie die Taste (66) "HF-Transistor-Überprüfung" vorgesehen sind, und dies in der Weise erfolgt, sodaß nach Rücksetzung der Schaltung über der Reset-Taste (14) die Taste (66) einmal betätigt wird, worauf einerseits über das RS-Kippglied (64) und dem daran angeschlossenen Delay-Flipflop (67) das retriggerbare Monoflop (68) getriggert wird und das simulierte CY-Signal über das angeschlossene Exor-Gatter (46) Einfluß auf die an der Taktleitung (47) angeschlossenen Delay-Flipflops (48) nimmt, womit von der NF- auf die HF-Transistor-Überprüfung geschaltet wird und anderseits ein prellfreier Impuls vom Ausgang des RS-Kippgliedes (64) über das R-D-R-Glied (65) zum Takteingang des Delay-Flipflops (69) gelangt, wodurch sich die Anzeige (55) "Vollmessung" verdunkelt und sein Q-Ausgang log. 1-Pegel annimmt, womit das Und-Gatter (58) in der Weise vorbereitet ist, daß ein vom Monoflop (59) kommendes Signal über das Und-Gatter (58) gelangen kann, und der Oszillator nach Abschluß der letzten HF-Transistor-Überprüfung gestoppt wird.

5. Transistormeßgerät nach einem der Ansprüche 1 bis 4, dadurch gekennzeichnet, daß das elektromechanische Bauteil "Relais" durch eine vollelektronische- und kontaktlose Schaltung "W"/(35) ersetzt wird, wobei dies ist in der Weise erfolgt, daß 50 der an der Basis eines Längstransistors (41) angeschlossene Transistor (42) zur Steuerung des Transistors (41) herangezogen wird und einerseits die Kollektor-Emitterstrecke vom Tr. (41) niederohmig bleibt, wenn an der Basis vom Transistor (42) ein log. 0-Pegel anliegt und anderseits die Kollektor-Emitterstrecke des Tr. (41) Hochomigkeit zeigt, wenn am Steuereingang (43) ein log. 1-Pegel anliegt, wobei durch die Reihenschaltung der Kollektor-Emitter-Strecke eines dritten Transistors (44) mit der Kollektor-Emitter-Strecke des Transistor (41) und dem Anschluß seiner Basis am Steuereingang (43) ein "regelbarer Widerstand" geschaffen worden ist, an dessen Kollektor die Ausgangsspannung U_{A} abgreifbar ist.

6. Transistormeßgerät nach einem der Ansprüche 1 bis 5, bei dem eine Schaltzeitmeßeinrichtung (7) vorgesehen ist, womit Transistoren bezüglich ihrer Durchschaltgeschwindigkeit unter gleichnamigen Typen selektiert werden können, und sich dadurch kennzeichnet, daß
a.) die vom Start/Stop-Oszillator (12) kommenden Signale zur Meßeingangsbuchse (77) gelangen, wobei mit jedem log.1-Pegel eine Zeitmessung eingeleitet wird und die Zeitmessung mit dem von der Auswertlogik (5) auf den Takteingang des Delay-Flipflop (87) gelangendem Stop-Signal ihren Abschluß findet und ferner einerseits mit jedem log. 1-Pegel an der Meßeingangsbuchse (77) über das Oder-Gatter (78) und dem Und-Gatter (79) das Und-Gatter (80) für die vom X-TAL-Oszillator (81) kommenden Impulse durchlässig geschaltet ist, sodaß die Oszillatorimpulse im Zähler (88) einlaufen können, wobei mit dem log.1-Pegel zeitgleich das Monoflop (83) über das Oder-Gatter (82) getriggert wird, wodurch der aktuelle Zählerstand nicht gelöscht wird und anderseits das Und-Gatter (80) durch einen log.0-Pegel am Meßeingang (77) undurchlässig für die vom X-TAL-Oszillator (81) kommenden Impulse geschaltet wird und darüber hinaus das Monoflop (83) nicht mehr getriggert wird, womit der Zählerstand des Zählers (88) beim Nichterscheinen des Stop-Signals auf den Takteingang des Flipflops (87) durch das Erscheinen eines log.0-Pegels über das Monoflop (83) am Reset-Eingang (85) gelöscht wird und die Schaltzeitmeßeinrichtung (7) für die nächste Messung vorbereitet ist, und das
b. eine Schaltungserweiterung der Schaltzeitmeßeinrichtung (7) vorgesehen ist, wodurch externe Schaltzeit- und Impulsmessungen durchgeführt werden können, wie beispielsweise die Messung der Langlebigkeit von einmal auftretenden Impulsen oder solchen Impulsen, wie sie von Monoflopschaltungen erzeugt werden, wobei dies in der Weise erfolgt, daß über der Eingabetaste (89) die Schaltzeitmeßeinrichtung (7) für externe Messungen vorbereitet wird und dadurch einerseits über das RS-Kippglied (90) und dem Delay-Flipflop (91) das Und-Gatter (92) freigeschaltet wird, was an der dann aktiven Leuchtanzeige (96) ersichtlich ist und anderseits über der Eingangsbuchse (93) das zu messende Signal mit dem Pegelwechsel von log.0 -auf- log.1 die Messung selbstätig einleitet, wobei mit abfallendem Pegel des zu messenden Signals über den Inverter (94) eine Taktflanke gebildet wird, mit dem das Delay-Flipflop (95) über das Und-Gatter (92) beaufschlagt wird und das dann mit dem an seinem Q-Ausgang erscheinendem Signal das Und-Gatter (79) schließt, sodaß kein weiteres Eingangssignal über Buchse (93) Einfluß auf die Meßschaltung (7) nehmen kann und darüber hinaus die gemessene Zeit direkt von der Sieben-Segment-Anzeige (88) ablesbar ist und bis zur Betätigung der Reset-Taste (14) im Zähler (88) gespeichert bleibt.

7. Transistormeßgerät nach einem der Ansprüche 1 bis 6, in dem das nach (G 93 18 765.3) angemeldete vollelektronische und kontaktlose Relais Einsatz findet und a.) das elektromechanische Relais (53) als auch b.) jedes der elektromechanischen Relais (34) ersetzen kann und sich dadurch kennzeichnet, daß einerseits eine am Steuereingang (137) anliegende positive Spannung das Aufhellen der Lumineszenzdiode (138) bewirkt, welche das optische Signal als Koppelelement auf den Flächen der lichtempfindlichen Fototransistoren (139) strahlt, worauf die Isolationsschichten vom extrem hochohmigen in den niederohmigen Zustand wechseln und die Strecke Klemme A (140)/Klemme K (141) und umgekehrt über den Fototransistor (139) für den anliegenden Strom keinen Widerstand mehr darstellen, wobei der angeordnete Inverter (142) die Lumineszenzdiode (143) dunkel schaltet und die Isolationsschichten der Fototransistoren (144) Hochohmigkeit zeigen und keinen Stromfluß von Klemme B (145) nach Klemme K (141) und umgekehrt erlauben und anderseits bei einem log.0-Pegel am Steuereingang "S" (137) sich die Strecken Klemme A (140)/Klemme K (141) und umgekehrt von der hochohmigen Seite zeigen bzw. die Strecken Klemme B (145)/Klemme K (141) in beiden Richtungen niederohmige Eigenschaften aufweisen, da die Lumineszenzdiode (143) über den Inverter (142) aktiviert wurde, worauf die Isolationsschichten der Fototransistoren (144) im niederohmigen Bereich kehren, und darüber hinaus die Widerstände (146) mit ihrem Wert den Lichtstrom der Diode (138, 143) bestimmen und damit den Isolationswiderstand der Fototransistoren (139, 144).

8. Transistormeßgerät nach einem der Ansprüche 1 bis 7, bei dem das elektromechanische Relais Fig. 5/Fig. 10 (110) durch einen lichtgesteuerten AC/DC-Umschalter (Fig. 13, Fig. 14) ersetzt werden kann, wodurch sich einerseits eine direkte und verzögerungsfreie Spannungsanzeige verwirklichen läßt, und sich anderseits eine wesentlich günstigere Verdrahtung ergibt und sich dieser dadurch kennzeichnet, daß vier als Spannungsfolger aufgebaute Differenzverstärker (114, 115, 116, 117) vorgesehen sind wobei jeder nichtinvertierende Verstärkereingang über die Kollektor-Emitter-Strecke eines Fototransistors (118, 119, 120, 121) zum Bezugspotential geschaltet ist und einerseits beim Anliegen eines log.1-Pegel am gemeinsamen Steuereingang "S" (122) die Transistoren (123, 124) durchgeschaltet werden und die in deren Kollektorkreisen befindlichen Fotodioden (125, 126) mit ihrem Lichtstrom die Durchschaltung der Fototransistoren (119, 121) zum Bezugspotential bewirken, womit nur die an den Eingängen E1 und E (1) (127, 128) anliegenden Signale zu den Ausgängen A1 und A (1) (129, 130) geschaltet werden und anderseits nur die an den Eingängen E2 und E (2) (131, 132) anliegenden Analogsignale zu den Ausgängen A 1 und A (1) (129, 130) durchgeschaltet werden, wenn sich am Steuereingang "S" (122) ein log. 0-Pegel einstellt, wobei über den Transistoren (133, 134) die Fotodioden (135, 136) aktiviert werden die ihrerseits die Fototransistoren (118, 120) durchschalten lassen und die Signale an den Eingängen E1 und E (1) (127, 128) nicht zu den Ausgängen A 1 und A (1) (129, 130) gelangen können.

9. Transistormeßgerät nach einem der Ansprüche 1 bis 8, welche eine Schaltungseinheit vorsieht, die selbstätig und ohne äußeres Hinzutun eine Überprüfung der korrekten Kontaktgebung des Prüflings mit der Meßelektronik durchführt und dieses sowohl akustisch als auch digital zur Anzeige bringt und ferner vor Durchführung einer Transistorüberprüfung die Aussage erbringen kann, ob der Transistor defekt ist oder nicht und sich dadurch kennzeichnet, daß
a.) nach Anschluß/"Kontaktgebung" des Prüflings mit der Meßeingangsbuchse (157) die Taste (148) einmal betätigt wird, worauf das Delay-Flipflop (153) vom RS-Flipflop (152) getaktet wird und die Leuchtanzeige "Keine Kontaktgebung" (150) aufhellen läßt und ferner dann 1.) den Oszillator (154) aktiviert, 2.) die Bedingung für das UND-Gatter (155) erfüllt, sodaß die getastete Gleichspannung zur Eingangsbuchs (159) des NC-Dekoders (158) gelangen kann, als auch 3.) das Relais (156) anziehen läßt, womit der Prüfling Transistor über der Meßeingangsbuchse (157) mit den Eingängen (166, 167, 168) des NC-Dekoders (158) verbunden ist, wobei bei korrekter Kontaktgebung des Transistors mit der Meßeingangsbuchse (157) am Meßpunkt (160) ein log.1-Pegel erscheint, welcher einerseits das nicht retriggerbare Monoflop (161) für die Dauer einer beliebig einstellbaren Zeit (hier : 1-Sekunde) aktiviert, als auch anderseits über das EXOR-Gatter (163) das Delay-Flipflop (153) rücksetzt, wodurch : 1.) die Anzeige "Keine Kontaktgebung" (150) inaktiviert wird, 2.) die optische Anzeige "Korrekte Kontaktgebung gegeben" (149) aufhellt, 3.) der Oszillator (154) gestoppt wird, 4.) die Bedingungen für das UND-Gatter (155) aufgehoben werden, 5.) das Relais (156) abfällt und der Prüfling mit der Relaiskarte (5) verbunden wird, womit sich die gesamte Schaltung nach einer vorprogrammierbaren Zeit (hier: 1/2-Sekunde) in Ausgangssituation befindet, wo hingegen bei keiner korrekten Kontaktgebung des Prüflings mit der Meßeingangsbuchse (157) am Ausgang (160) des NC-Dekoders (158) ein log.0-Pegel erscheint, worauf die Schaltung nicht in Ausgangssituation rückgesetzt wird, was an der dann ständig blinkenden optischen Leuchtanzeige "Keine Kontaktgebung" (150) ersichtlich ist und darüber hinaus nach Betätigung der "NC-Return"-Taste (164) die Schaltung in Ausgangssituation rückgesetzt wird und die Wiederholung der oben beschriebenen Überprüfung mit gleichem Resultat die Aussage erlaubt, daß der Prüfling Transistor defekt ist, was im anschließendem Prüfverfahren definitiv mitgeteilt werden kann, und daß sich
b. der NC-Dekoder Fig. 18 (158) aus drei gleichartig aufgebauten Logikschaltungen (165) zusammensetzt, deren Eingänge (166, 167, 168) über den relaisgesteuerten Schaltern (169, 170, 171) in direkter Verbindung mit der Meßeingangsbuchse (157) stehen und deren Ausgänge (172, 173, 174) mit dem UND-Gatter (175) verbunden sind wobei bei einer korrekten Kontaktgebung des Transistors mit der Meßeingangsbuchse (157) einerseits nur bei einem intakten Prüfling an allen drei Eingängen (166, 167, 168) das über das UND-Gatter (155) gelangende Rechtecksignal anliegt, welches vom NAND-Gatter (176) durch die Widerstände (177, 178) in der Art umgeformt wird, sodaß sich an den NAND-Gatter-Ausgängen (179) ein log.1-Pegel einstellt, wobei diese log.1-Informationen über den Ausgängen (172, 173, 174) zum UND-Gatter (175) gelangen und sich am Ausgang des NC-Dekoders (158) bzw. an der Ausgangsbuchse (160) ein 0-auf-1-Signal einstellt und darüber hinaus der Akkustikwandler (151) über die Monoflop-schaltung (161) und dem Oszillator (162) kurzzeitig aktiviert wird und sich anderseits bei einer nicht korrekten Kontaktgebung des Prüflings mit der Meßeingangsbuchse (157) die getastete Gleichspannung nicht über den Unterbrechungen zu den Eingängen (166, 167, 168) gelangen kann, worauf die zugehörigen Logikschaltungen (165) die entsprechenden hochohmigen Eingänge (166, 167 oder 168) in der Weise auswertet, sodaß sich an der Ausgangsbuchse (172, 173 oder 174) ein log.0-Pegel einstellt, und sich am UND-Gatter-Ausgang (160) kein 0-auf-1-Signal einstellen kann, wodurch ferner der Oszillator (162) in den inaktiven Zustand verbleibt.

10. Transistormeßgerät nach einem der Ansprüche 1 bis 9, dadurch gekennzeichnet daß ein SMD-Bauteilprüfstift vorgesehen ist, welcher die direkte Überprüfung von aktiven SMD-Halbleiterbausteinen auf den Leiterplatten über nur einem dreiadrigen Meßkabel erlaubt, wobei das Meßkabel (180) einerseits mit der Meßeingangsbuchse (157) als auch anderseits über eine Klinkenkupplung (181) mit dem Klinkenstecker (182) des Tastkopfträgers (183) verbunden wird und über das Gewinde (184, 185) eine feste Verschraubung des Tastkopfes (186) mit dem Tastkopfträger (183) erfolgt, wobei der Tastkopf (186) selber Träger der drei Prüfspitzen (187) ist und die sichere elektrische Verbindung des dreiadrigen Meßkabels (180) mit den Prüfspitzen (187) durch Verlötung der Litzenenden mit dem Kelch (188) der Prüfspitzen (187) sichergestellt wird und darüber hinaus nach dem Herausziehen der Klinkenkupplung (181) aus dem Klinkenstecker (182) und dem Aufstecken einer abgerundeten Meßspitzenschutzkappe sich der SMD-Bauteil- prüfstift problemlos über den Haltebügel (189) in der Hemdtasche mitführen läßt.
